# EUROPEAN PATENT APPLICATION

(11) **EP 4 848 597 A1**
(43) Date of publication of application: **02.12.2026**
(21) Application number: 25762322.3
(22) Date of filing: 11.02.2025
(51) Int. Cl.: H04B 1/50, H04B 1/401, H04W 76/16, H01G 4/12, H04B 1/04

(54) **RADIO FREQUENCY FRONT-END MODULE AND ELECTRONIC DEVICE INCLUDING SAME**

(30) Priority: 28.02.2024 KR 20240028936; 27.03.2024 KR 20240042144
(71) Applicant: Samsung Electronics Co., Ltd., Suwon-si, Gyeonggi-do 16677 (KR)
(72) Inventor: KANG, Hyunsang, Suwon-si Gyeonggi-do 16677 (KR); NA, Hyoseok, Suwon-si Gyeonggi-do 16677 (KR); RYU, Gyeonghun, Suwon-si Gyeonggi-do 16677 (KR); MOON, Yohan, Suwon-si Gyeonggi-do 16677 (KR); VAN, Juho, Suwon-si Gyeonggi-do 16677 (KR)
(74) Representative: Gulde & Partner
(86) International application number: PCT/KR2025/001996
(87) International publication number: WO 2025/183388

(57) **Abstract**

In embodiments of the present disclosure, an electronic device is provided. The electronic device may comprise: a processor including a processing circuit; a radio frequency (RF) transceiver; a first power supply circuit configured to provide a first supply voltage based on average power tracking (APT); a second power supply circuit configured to provide a second supply voltage based on APT; a switching circuit for selectively connecting one of the first power supply circuit and the second power supply circuit to a power path; a first radio frequency front-end (RFFE) module including a first power amplifier connected to the power path; a second RFFE module including a second power amplifier connected to the power path; a third RFFE module including a third power amplifier connected to the second power supply circuit; a first capacitor connected to the first RFFE module; a second capacitor connected to the second RFFE module; and a third capacitor connected to the third RFFE module.

## Description

### [Technical Field]

The following descriptions relate to a radio frequency front end module and an electronic device including the same.

### [Background Art]

An electronic device may include radio frequency front end (RFFE) modules for transmitting or receiving a signal. For example, an RFFE module may include a power amplifier (PA) for transmit power of a signal to be transmitted through an antenna connected to the RFFE module.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments of the present disclosure, an electronic device is provided. The electronic device may comprise a processor comprising one or more processing circuitry, a radio frequency (RF) transceiver, a first power supply circuitry, a second power supply circuitry configured to provide a supply voltage based on average power tracking (APT), and a switching circuit for selectively electrically connecting a power path to one of the first power supply circuitry and the second power supply circuitry, and may comprise a first radio frequency front end (RFFE) module including a first power amplifier connected to the power path, a second RFFE module including a second power amplifier connected to the power path, a third RFFE module including a third power amplifier connected to the second power supply circuitry, at least one capacitor connected to the second power supply circuitry, and at least one capacitor connected to the power path. The switching circuit may be configured to, in accordance with control of the processor or the RF transceiver, connect the power path and the second power supply circuitry while power amplifiers connected to the power path, including the first power amplifier and the second power amplifier, are disabled, and signals are transmitted through the third power amplifier connected to the second power supply circuitry.

In embodiments of the present disclosure, an electronic device is provided. The electronic device may comprise a processor comprising one or more processing circuitry, a radio frequency (RF) transceiver, a plurality of power supply circuitry including power supply circuitry configured to provide a supply voltage based on average power tracking (APT), a first radio frequency front end (RFFE) module including a switching circuit for selectively electrically connecting one of the plurality of power supply circuitry to a power path, at least one second RFFE module connected to the power path, a third RFFE module connected to a path from the power supply circuitry, at least one capacitor connected to the power supply circuitry, and at least one capacitor connected to the power path. The switching circuit may be configured to, in accordance with control of the processor or the RF transceiver, connect the power path and the power supply circuitry while power amplifiers included in the first RFFE module and the at least one second RFFE module are disabled and signals are transmitted through a power amplifier of the third RFFE module.

In embodiments of the present disclosure, an electronic device is provided. The electronic device may comprise a processor comprising processing circuitry, a radio frequency (RF) transceiver, a first power supply circuitry configured to provide a first supply voltage based on average power tracking (APT), a second power supply circuitry configured to provide a second supply voltage based on APT, a switching circuit for selectively connecting a power path to one of the first power supply circuitry and the second power supply circuitry, a first radio frequency front end (RFFE) module including a first power amplifier connected to the power path, a second RFFE module including a second power amplifier connected to the power path, a third RFFE module including a third power amplifier connected to the second power supply circuitry, a first capacitor connected to the first RFFE module, a second capacitor connected to the second RFFE module, and a third capacitor connected to the third RFFE module. The switching circuit may be configured to, in accordance with control of the processor or the RF transceiver, connect the power path and the second power supply circuitry while power amplifiers connected to the power path, including the first power amplifier and the second power amplifier, are disabled, and the third power amplifier, connected to the second power supply circuitry, is enabled to transmit RF signals on a frequency band supported in the third RFFE module. The first capacitor, the second capacitor, and the third capacitor may be used for the second supply voltage based on the APT while the power path and the second power supply circuitry are connected. Transmit power for the frequency band supported in the third RFFE module may be higher than transmit power for a frequency band supported in the first RFFE module and may be higher than transmit power for a frequency band supported in the second RFFE module.

In embodiments of the present disclosure, an electronic device is provided. The electronic device may comprise a processor comprising processing circuitry, a radio frequency (RF) transceiver, a power supply circuitry configured to supply voltage based on average power tracking (APT), a switching circuit, a first radio frequency front end (RFFE) module including a first power amplifier, a second RFFE module including a second power amplifier, a third RFFE module including a third power amplifier, a first path provided between the power supply circuitry and the switching circuit, a second path provided between the switching circuit and each of power amplifiers including the first power amplifier and the second power amplifier, a third path provided between a node on the first path and the third power amplifier, a first capacitor connected to the first path, a second capacitor connected to the second path, and a third capacitor connected to the third path. In case that the first power amplifier is enabled, the second power amplifier is disabled, and the third power amplifier is disabled, the switching circuit may be controlled to connect the first power amplifier to receive supply voltage from the power supply circuitry through the first path and the second path to amplify first RF signals from the RF transceiver and transmit the amplified first RF signals on a first frequency band with first transmit power. In case that the first power amplifier is disabled, the second power amplifier is enabled, and the third power amplifier is disabled, the switching circuit may be controlled to connect the second power amplifier to receive supply voltage from the power supply circuitry through the first path and the second path to amplify second RF signals from the RF transceiver and transmit the amplified second RF signals on a second frequency band with second transmit power. In case that the first power amplifier is disabled, the second power amplifier is disabled, and the third power amplifier is enabled, the switching circuit may controlled to connect the first capacitor, the second capacitor, and the third capacitor while the third power amplifier is connected to receive supply voltage from the power supply circuitry through the third path to amplify third RF signals from the RF transceiver and transmit the amplified third RF signals on a third frequency band with third transmit power, by connecting the first path and the second path. The third transmit power of the amplified third RF signals on the third frequency band may be higher than the first transmit power of the amplified first RF signals on the first frequency band and may be higher than the second transmit power of the amplified second RF signals on the second frequency band.

In embodiments of the present disclosure, an electronic device is provided. The electronic device may comprise a processor comprising processing circuitry, a radio frequency (RF) transceiver, a power supply circuitry configured to supply voltage based on average power tracking (APT), a switching circuit, a first radio frequency front end (RFFE) module including a first power amplifier, a second RFFE module including a second power amplifier, a third RFFE module including a third power amplifier, a first path provided between the power supply circuitry and the switching circuit, a second path provided between the switching circuit and each of power amplifiers including the first power amplifier and the second power amplifier, a third path provided between a node on the first path and the third power amplifier, a first capacitor connected to the first path, a second capacitor connected to the second path, and a third capacitor connected to the third path. In case that the first power amplifier is disabled, the second power amplifier is disabled, and the third power amplifier is enabled to amplify first RF signals from the RF transceiver to be transmitted on a first frequency band supported in the third RFFE module through an antenna, the switching circuit may be configured to operate in a state in which the first path and the second path are not connected. In case that the first power amplifier is disabled, the second power amplifier is disabled, and the third power amplifier is enabled to amplify second RF signals from the RF transceiver to be transmitted on a second frequency band supported in the third RFFE module through an antenna, the switching circuit may be configured to connect the first path and the second path to use the first capacitor, the second capacitor, and the third capacitor while the supply voltage based on the APT is provided to the third power amplifier.

### [Description of the Drawings]

FIG. 1 is a block diagram of an electronic device in a network environment.
FIG. 2 indicates an example of an electronic device including a power supply module and radio frequency front end (RFFE) modules.
FIG. 3 indicates an example of an operation of a switching circuit in an RFFE module for signal transmission in a designated frequency band.
FIG. 4 indicates an example of an operation of a switching circuit in a power supply module for signal transmission in a designated frequency band.
FIGS. 5A and 5B indicate an example of an operation of a switching circuit in an RFFE module for signal transmission in a designated frequency band.
FIG. 6 indicates an operation flow of an electronic device for transmitting a signal in a designated frequency band.
FIG. 7 indicates an operation flow of an electronic device for transmitting a signal in a designated frequency band.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a part of an electronic device (e.g., a communication module, a wireless communication module, a substrate, a printed circuit board (PCB), a flexible PCB (FPCB), a module, an antenna, an antenna element, circuitry, a processor, a chip, a component, or a device), a term referring to an RF-related component (e.g., a front end module (FEM), a power amplifier module (PAM), a FEM including duplexer (FEMid), a power amplifier module including duplexer (PAMid), a Low noise amplifier PAM including duplexer (LPAMid), a radio frequency front end (RFFE), or a radio frequency integrated circuit (RFIC)), a term referring to a shape of a component (e.g., a structure, a construction, a support portion, a contact portion, or a protrusion portion), a term referring to the connection between structures (e.g., a connection portion, a contact portion, a support portion, a contact structure, a conductive member, an assembly), a term referring to a circuit (e.g., a PCB, a FPCB, a signal line, a feeding line, a data line, an RF signal line, an antenna line, a signal path, an RF path, an RF module, an RF circuit, a splitter, a divider, a coupler, or a combiner), and the like, used in the following description, are exemplified for convenience of explanation. Therefore, the present disclosure is not limited to terms to be described below, and another term having an equivalent technical meaning may be used. In addition, a term such as '...unit, '...device, '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

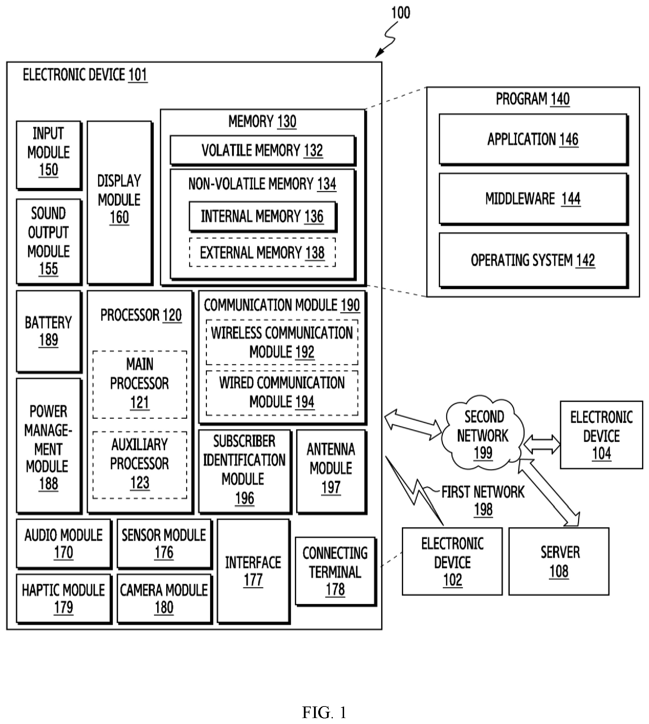

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

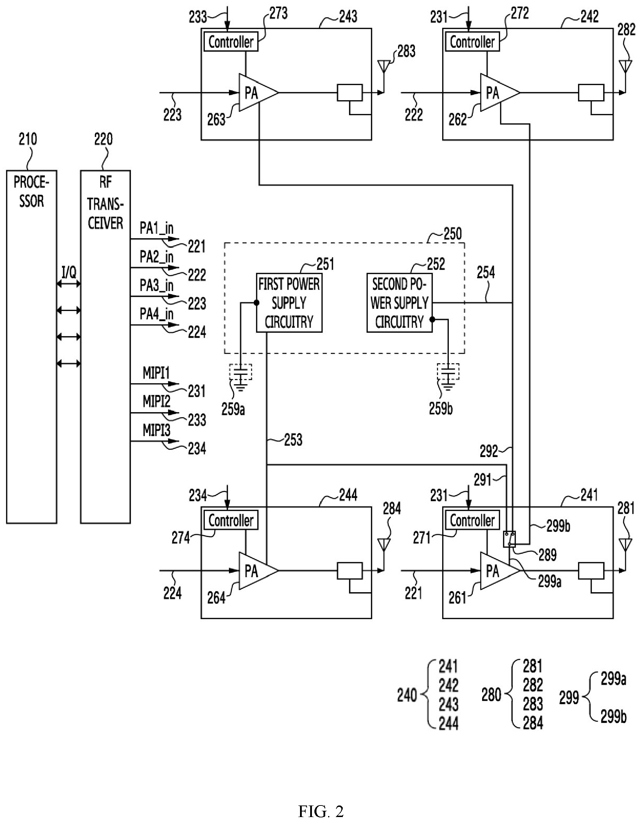

FIG. 2 indicates an example of an electronic device (e.g., the electronic device 101 of FIG. 1) including a power supply module and radio frequency front end (RFFE) modules.

Referring to FIG. 2, the electronic device 101 may include a processor 210, an RF transceiver 220, RFFE modules 240, a power supply circuitry 250, and antennas 280. The electronic device 101 may include the processor 210. The processor 210 may include at least one of, for example, an application processor (AP) (e.g., the main processor 121 of FIG. 1) or a communication processor (CP) (e.g., the auxiliary processor 123 of FIG. 1). For example, the processor 210 may include the AP and the CP. For example, the processor may include the AP. For example, the processor 210 may include the CP. The processor 210 may control the RF transceiver 220 through a control interface. The processor 210 may control the RF transceiver 220 to transmit a signal through an antenna (e.g., at least one of the antennas 280). The processor 210 may control the RF transceiver 220 to receive a signal.

The electronic device 101 may include the RF transceiver 220. For example, the RF transceiver 220 may be implemented as a single chip (e.g., an RFIC chip) or as a portion of a single package. The RF transceiver 220 may include a digital to analog converter (DAC) for converting a digital signal into an analog signal. The RF transceiver 220 may include a mixer and an oscillator (e.g., a local oscillator (LO)) for up-conversion. The RF transceiver 220 may convert a baseband signal generated by the processor 210 into an RF signal. The RF transceiver 220 may provide an RFFE module (e.g., at least one of the RFFE modules 240) with an RF signal. The RF transceiver 220 may include an analog to digital converter (ADC) for converting an analog signal into a digital signal. The RF transceiver 220 may include a mixer and an oscillator for down-conversion. The RF transceiver 220 may convert an RF signal received from an antenna (e.g., at least one of the antennas 280) into a baseband signal to be processed by the processor 210. The RF transceiver 220 may include one or more transmission ports. The RF transceiver 220 may include one or more receiving ports. According to an embodiment, the RF transceiver 220 may control at least a portion of the RFFE modules 240 and/or the power supply circuitry 250 (e.g., a first power supply circuitry 251 and a second power supply circuitry 252) through a mobile industry processor interface (MIPI) interface.

The electronic device 101 may include the RFFE modules 240 (or RFFE circuits) to support various frequency bands. For example, the electronic device 101 may include a first RFFE module 241, a second RFFE module 242, a third RFFE module 243, and/or a fourth RFFE module 244. Each RFFE module may include a power amplifier (PA). For example, the first RFFE module 241 may include a first PA 261. The second RFFE module 242 may include a second PA 262. The third RFFE module 243 may include a third PA 263. The fourth RFFE module 244 may include a fourth PA 264. Each RFFE module may be connected to an antenna for transmitting a signal. For example, the first RFFE module 241 may be connected to a first antenna 281. The second RFFE module 242 may be connected to a second antenna 282. The third RFFE module 243 may be connected to a third antenna 283. The fourth RFFE module 244 may be connected to a fourth antenna 284. Although FIG. 2 illustrates an RFFE module including a power amplifier for a transmission path, embodiments of the present invention are not limited thereto. For example, not olny a PAMid including a transmission path, but also LPAMid further including a component (e.g., a low noise amplifier (LNA)) for a reception path may be used as an example of an RFFE module. A module including a power amplifier receiving a supply voltage from the power supply circuitry 250 (e.g., the first power supply circuitry 251 and the second power supply circuitry 252) may be understood as an RFFE module of the electronic device 101 according to an embodiment of the present disclosure. As a non-limiting example, in terms of being implemented as one module such as a chip, the RFFE module may be referred to as a wireless communication chip, an RF chip, a wireless transmission/reception chip, a wireless chip, a communication chip, and/or an equivalent technical term. In addition, for example, the RFFE module may be understood as communication circuitry including not only one module, but also a power amplifier and an FEMid, according to an implementation example.

The electronic device 101 may include the power supply circuitry 250. The power supply circuitry 250 may be controlled by the processor 120 and/or the RF transceiver 220. The power supply circuitry 250 may be configured to supply power to a plurality of RFFE modules (e.g., the RFFE modules 240). The power supply circuitry 250 may supply a plurality of powers for the plurality of RFFE modules. The power supply circuitry 250 may supply power to each RFFE module of the plurality of RFFE modules. For example, the power supply circuitry 250 may be a form in which a plurality of modulators are implemented as one module (or IC). The power supply circuitry 250 may be a power supply module including a plurality of cores. As an example, the power supply module may include the first power supply circuitry 251 and the second power supply circuitry 252. For another example, the power supply circuitry 250 may include the first power supply circuitry 251 and the second power supply circuitry 252 implemented as a separate module. Power being supplied to an RFFE module may indicate that a supply voltage is applied for a PA of the RFFE module. The power supply circuitry 250 may output a plurality of supply voltages for the plurality of RFFE modules. For example, the power supply circuitry 250 may output a first supply voltage 253 V_{CC1} from the first power supply circuitry 251 and a second supply voltage 254 V_{cc2} from the second power supply circuitry 252. For example, the first supply voltage 253 may be provided to the first RFFE module 241, the second RFFE module 242, and/or the fourth RFFE module 244. For example, the second supply voltage 254 may be provided to the first RFFE module 241, the second RFFE module 242, and/or the third RFFE module 243.

The first RFFE module 241 may include a switching circuit 289 for selecting one of the first supply voltage 253 and the second supply voltage 254. A first path 291 (or wiring) electrically connected to the first power supply circuitry 251 and a second path 292 (or wiring) electrically connected to the second power supply circuitry 252 may be connected to the switching circuit 289. The switching circuit 289 may be connected to a power path 299. The power path 299 indicates an electrical path (or wiring) that is connected to the switching circuit 289 and that provides a supply voltage provided through power supply circuitry (e.g., the first power supply circuitry 251 and the second power supply circuitry 252) to power amplifier(s). The power path 299 may provide a power supply V_{cc} provided from the power supply circuitry (e.g., the first power supply circuitry 251 and the second power supply circuitry 252) electrically connected through the switching circuit 289 to one of power amplifiers (e.g., the first PA 261 and the second PA 262) of RFFE modules connected to the power path 299. A branch (e.g., a first branch 299a) of the power path 299 may be configured to provide a supply voltage to the first PA 261, and another branch (e.g., a second branch 299b) of the power path 299 may be configured to provide an output voltage to the outside of the first RFFE module 241. For example, the other branch of the power path 299 may be connected to the outside of the first RFFE module 241 through an output voltage port Vₒᵤₜ of the first RFFE module 241. A portion of the power path 299 may include a wiring disposed outside the first RFFE module 241 and connected to another RFFE module (e.g., the second RFFE module 242). The electronic device 101 may provide the supply power V_{cc} to the second PA 262 of the second RFFE module 242 through the wiring of the power path 299. A circuitry structure in which two RFFE modules are connected to the power path 299 is illustrated in FIG. 2, but embodiments of the present disclosure are not limited thereto. Three or more RFFE modules may be connected through the power path 299.

The first RFFE module 241 may obtain a first transmission signal 221 from the RF transceiver 220. The first RFFE module 241 may amplify the first transmission signal 221 through the first PA 261. One of the first supply voltage 253 or the second supply voltage 254 may be applied to the first PA 261 for an operation of the first PA 261. The switching circuit 289 in the first RFFE module 241 may provide one of the first supply voltage 253 and the second supply voltage 254 to the first PA 261 through the power path 299 (e.g., the first branch 299a) connected to the first PA 261. The first transmission signal 221 amplified through the first PA 261 may be transmitted through the first antenna 281. Components of the first RFFE module 241 may operate in accordance with control of a first controller 271. The first controller 271 may be configured to receive a control signal from the processor 210 and/or the RF transceiver 220. For example, the first controller 271 may control the components (e.g., the first PA 261 and the switching circuit 289) in the first RFFE module 241 in accordance with a first MIPI signal 231 from the RF transceiver 220.

The second RFFE module 242 may obtain a second transmission signal 222 from the RF transceiver 220. The second RFFE module 242 may amplify the second transmission signal 222 through the second PA 262. One of the first supply voltage 253 or the second supply voltage 254 may be applied to the second PA 262 for an operation of the second PA 262. The switching circuit 289 in the second RFFE module 242 may provide one of the first supply voltage 253 and the second supply voltage 254 to the first PA 261 through the power path 299 (e.g., the second branch 299b) connected to the second PA 262. The second transmission signal 222 amplified through the second PA 262 may be transmitted through the second antenna 282. Components of the second RFFE module 242 may operate in accordance with control of a second controller 272. The second controller 272 may be configured to receive a control signal from the processor 210 and/or the RF transceiver 220. For example, the second controller 272 may control the components (e.g., the second PA 262) in the second RFFE module 242 in accordance with the first MIPI signal 231 from the RF transceiver 220. While signals are transmitted through the first PA 261, the second PA 262 connected to the same power path 299 may be required to be disabled. Similarly, while signals are transmitted through the second PA 262, the first PA 261 connected to the same power path 299 may be required to be disabled. For this control, the same MIPI signal (e.g., the first MIPI signal 231) is exemplified, but embodiments of the present disclosure are not limited thereto. Different control signals may be used to individually control the first RFFE module 241 and the second RFFE module 242. Hereinafter, in the present disclosure, a meaning of disabling a power amplifier indicates that the power amplifier does not operate so that signals are not amplified through the power amplifier. A meaning of enabling the power amplifier indicates that the power amplifier operates so that signals are amplified through the power amplifier. Enabling or disabling of the power amplifier may be performed by a controller of an RFFE module including the power amplifier, and the controller may operate in accordance with a control (e.g., a MIPI) signal of the processor 210 or the RF transceiver 220. To describe a state of such power amplifier, not only disable, but also deactivate, shut-off, turn-off, inactive, idle, non-operating mode, sleep mode, disable state, and/or an equivalent technical terms may be used.

The third RFFE module 243 may obtain a third transmission signal 223 from the RF transceiver 220. The third RFFE module 243 may amplify the third transmission signal 223 through the third PA 263. The second supply voltage 254 from the second power supply circuitry 252 may be applied to the third PA 263 for an operation of the third PA 263. The third transmission signal 223 amplified through the third PA 263 may be transmitted through the third antenna 283. Components of the third RFFE module 243 may operate in accordance with control of a third controller 273. The third controller 273 may be configured to receive a control signal from the processor 210 and/or the RF transceiver 220. For example, the third controller 273 may control the components (e.g., the third PA 263) in the third RFFE module 243 in accordance with a second MIPI signal 233 from the RF transceiver 220.

The fourth RFFE module 244 may obtain a fourth transmission signal 224 from the RF transceiver 220. The fourth RFFE module 244 may amplify the fourth transmission signal 224 through the fourth PA 264. The first supply voltage 253 from the second power supply circuitry 251 may be applied to the fourth PA 264 for an operation of the fourth PA 264. The fourth transmission signal 224 amplified through the fourth PA 264 may be transmitted through the fourth antenna 284. Components of the fourth RFFE module 244 may operate in accordance with control of a fourth controller 274. The fourth controller 274 may be configured to receive a control signal from the processor 210 and/or the RF transceiver 220. For example, the fourth controller 274 may control the components (e.g., the fourth PA 264) in the fourth RFFE module 244 in accordance with a third MIPI signal 234 from the RF transceiver 220.

A current consumed by a power amplifier in the electronic device 101 may have a significant influence on battery usage time of a user. In accordance with development of communication technology, an average power tracking (APT) technology may be used to provide a supply voltage of an appropriate size. APT is a technology for providing a DC voltage of a size in accordance with a communication channel state to the power amplifier. For a supply voltage in accordance with the APT, the power supply circuitry 250 may be configured to provide power to the power amplifier by a designated size through a DC-DC converter. In addition to APT, the APT may be used with terms such as an APT mode, an APT state, an APT operation, an APT method, a variable DC voltage mode, a variable DC power mode, and/or a term having an equivalent technical/functional meaning. The power supply circuitry 250 may be configured to provide a supply voltage based on the APT. For example, the first power supply circuitry 251 may be configured to provide the first supply voltage 253 based on the APT. For example, the second power supply circuitry 252 may be configured to provide the second supply voltage 254 based on the APT. In order to generate the supply voltage in accordance with the APT, each power supply circuitry may include an APT switch (not illustrated) and a buck converter circuitry (not illustrated). The APT switch may be configured to electrically connect a capacitor to the buck converter circuitry. The supply voltage in accordance with the APT may be affected by a capacitor. A DC voltage may be generated through the buck converter circuitry, and the capacitor may be used to maintain a constant voltage. For example, the first power supply circuitry 251 may be electrically connected to a first APT capacitor 259a to maintain the first supply voltage 253 constantly in accordance with the APT. For example, the second power supply circuitry 252 may be electrically connected to a second APT capacitor 259b to maintain the second supply voltage 254 constantly in accordance with the APT.

The higher an output required by a power amplifier, the greater the current consumption, and thus a higher capacity capacitor may be required. For example, a relatively large capacity capacitor may be connected to a power supply circuitry to amplify signals of a frequency band that supports a specific wireless connection technology (e.g., a global system for mobile communications (GSM)). A multilayer ceramic capacitor (MLCC) capacitor may be considered to support a large capacity within a limited mounting area, but as a voltage applied to both ends of the MLCC capacitor changes, physical deformation of the capacitor may be caused and a PCB in which the MLCC capacitor is disposed may vibrate. Audible noise may be generated by these physical deformation and vibration. In order to reduce an electric field generated while providing the equivalent capacitance, a method of arranging a plurality of capacitors in parallel instead of one large capacitor may be considered, but it may be disadvantageous in terms of cost and space. The plurality of capacitors may be coupled in parallel.

To alleviate the above-described problems, in the present disclosure, a circuitry structure including a capacitor (e.g., the first APT capacitor 259a and the second APT capacitor 259b) connected to power supply circuitry and capacitors (e.g., a decoupling capacitor connected to an RFFE module) for another purpose, is described. A supply voltage (e.g., a second supply voltage 254 from the second power supply circuitry 252) in accordance with APT may be provided to a power amplifier (e.g., the third PA 263 of the third RFFE module 243) for a high-output signal through the switching circuit 289 in the circuitry structure and capacitors electrically disposed in parallel. While the supply voltage 254 in accordance with the APT is provided to the third RFFE module 243 in the second power supply circuitry 252, multiple capacitors may be electrically disposed in parallel through an operation of the switching circuit 289. Hereinafter, in the present disclosure, an example in which the supply voltage (e.g., the second supply voltage 254) in accordance with the APT in the second power supply circuitry 252 is provided to the third RFFE module 243 is described, but embodiments of the present disclosure are not limited thereto. The first power supply circuitry 251 may also provide the supply voltage 253 in accordance with the APT, and embodiments of the present disclosure to be described later may also be applied for an high-output operation of the fourth RFFE module 244.

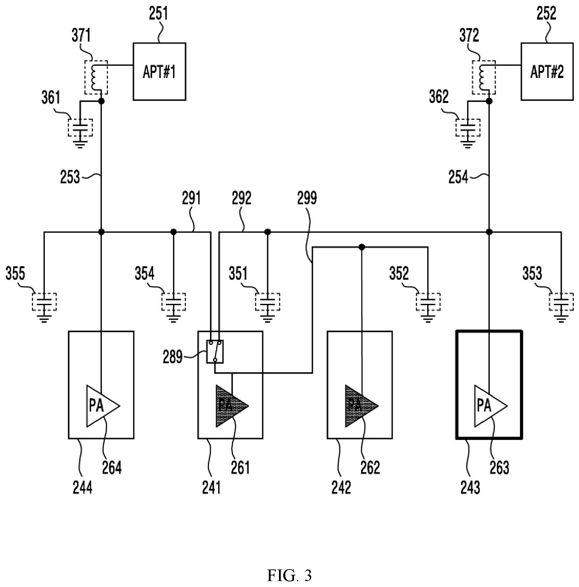

FIG. 3 indicates an example of an operation of a switching circuit (e.g., a switching circuit 289) in an RFFE module (e.g., a first RFFE module 241) for signal transmission in a designated frequency band. In FIG. 3, a circuitry structure including capacitors electrically disposed in parallel in accordance with an operation of the switching circuit 289 is described. The same reference number may be used for the same description.

Referring to FIG. 3, an electronic device 101 may include first power supply circuitry 251 and second power supply circuitry 252. For example, the first power supply circuitry 251 may provide a first supply voltage 253 based on APT. The electronic device 101 may include a first APT capacitor 361 and a first inductor 371. A buck converter circuitry of the first power supply circuitry 251 may be configured to output the first supply voltage 253 through the first inductor 371. In order to stably provide the first supply voltage 253 in accordance with the APT, the first APT capacitor 361 may be connected to a path through which the first supply voltage 253 is outputted. For example, the second power supply circuitry 252 may provide a second supply voltage 254 based on APT. The electronic device 101 may include a second APT capacitor 362 and a second inductor 372. A buck converter circuitry of the second power supply circuitry 252 may be configured to output the second supply voltage 254 through the second inductor 372. In order to stably provide the second supply voltage 254 in accordance with the APT, the second APT capacitor 362 may be connected to a path through which the second supply voltage 254 is outputted.

The electronic device 101 may include RFFE modules. For example, the electronic device 101 may include a first RFFE module 241, a second RFFE module 242, a third RFFE module 243, and/or a fourth RFFE module 244. The first RFFE module 241 may include a first PA 261. The second RFFE module 242 may include a second PA 262. The third RFFE module 243 may include a third PA 263. The fourth RFFE module 244 may include a fourth PA 264.

The electronic device 101 may supply the first supply voltage 253 or the second supply voltage 254 to the first PA 261 of the first RFFE module 241 to drive the first PA 261. The electronic device 101 may provide the first supply voltage 253 or the second supply voltage 254 to the first PA 261 through the switching circuit 289 and a power path 299. As a non-limiting example, the first RFFE module 241 may be configured to perform processing of signals of a frequency band in a first frequency range. As an example, the first frequency range may include a frequency band of a high frequency band (e.g., an ultra-high band (UHB) greater than or equal to approximately 3.4 GHz).

The electronic device 101 may supply the first supply voltage 253 or the second supply voltage 254 to the second PA 262 of the second RFFE module 242 to drive the second PA 262. The electronic device 101 may provide the first supply voltage 253 or the second supply voltage 254 to the second PA 262 through the switching circuit 289 and the power path 299. As a non-limiting example, the second RFFE module 242 may be configured to perform processing of the signals of the frequency band in the first frequency range. As an example, the first frequency range may include the high band (e.g., the UHB greater than or equal to approximately 3.4 GHz).

The electronic device 101 may supply the second supply voltage 254 to the third PA 263 of the third RFFE module 243 to drive the third PA 263. As a non-limiting example, the third RFFE module 243 may be configured to perform processing of signals of a frequency band in a second frequency range. As an example, the second frequency range may include a low band (e.g., a low-band (LB) of less than approximately 1 GHz or a GSM frequency band).

The electronic device 101 may supply the first supply voltage 253 to the fourth PA 264 of the fourth RFFE module 244 to drive the fourth PA 264. As a non-limiting example, the fourth RFFE module 244 may be configured to perform processing of signals of a frequency band between the first frequency range and the second frequency range. As an example, the frequency band may include a mid-band (e.g., a frequency band greater than or equal to approximately 1 GHz and less than approximately 2.3 GHz) and a high band (e.g., a frequency band greater than or equal to approximately 2.3 GHz).

The electronic device 101 may control the switching circuit 289 to selectively connect a first path 291 or a second path 292 to the power path 299. For example, the switching circuit 289 may provide the first supply voltage 253 from the first power supply circuitry 251 to one of power amplifiers (e.g., the first PA 261 and the second PA 262) connected to the power path 299 in accordance with control of a processor 210 or an RF transceiver 220. For example, the switching circuit 289 may provide the second supply voltage 254 from the second power supply circuitry 252 to one of the power amplifiers (e.g., the first PA 261 and the second PA 262) connected to the power path 299 in accordance with control of the processor 210 or the RF transceiver 220. For example, the switching circuit 289 may not electrically connect the power path 299 to both the first path 291 and the second path 292 in accordance with control of the processor 210 or the RF transceiver 220. A state in which the power path 299 is not connected to any path may be referred to as an isolation state, a neutral state, a parking state, and/or an equivalent technical term.

According to embodiments of the present disclosure, the switching circuit 289 may be configured to electrically connect the second path 292 to the power path 299 even if the second supply voltage 254 is not provided to any power amplifier of the power amplifiers (e.g., the first PA 261, and the second PA 262) connected to the power path 299. The switching circuit 289 may be configured to electrically connect the second path 292 to the power path 299 while the power amplifiers (e.g., the first PA 261 and the second PA 262) connected to the power path 299 are disabled and signals (e.g., a third transmission signal 233) are amplified through the third PA 263. Since all power amplifiers connected to the power path 299 are disabled, even if the power path 299 is connected to the second path 292, it may be understood that the second supply voltage 254 is not applied through each power amplifier in the power path 299. With respect to a path from the second power supply circuitry 252 to the third RFFE module 243, a first capacitor 351, a second capacitor 352, a third capacitor 353, and the second APT capacitor 362 to be described later may be disposed in parallel.

The signals amplified through the third PA 262 may be transmitted in a designated frequency band (e.g., a GSM frequency band, a frequency band for satellite communication, a frequency band of power class (PC) 1.5 among LTE frequency bands or NR frequency bands, a frequency band of PC 2 among LTE frequency bands or NR frequency bands, and the like). As an example, the designated frequency band may mean a frequency band that requires transmission power higher than a certain standard. As a non-limiting example, in a case that the third PA 262 is amplified to transmit a signal of another frequency band (e.g., a low band of LTE and NR) supported in the third RFFE module 243, the electronic device 101 may operate in an isolation state or control the switching circuit 289 to be connected to the first power supply circuitry 251. Since transmission power required in the other frequency band is lower than transmission power in the designated frequency band, a relatively small size of capacitance may be required for a supply voltage in accordance with APT. In other words, the transmission power required in the designated frequency band is relatively higher than the transmission power required in the other frequency band, a relatively large size of capacitance may be required.

The electronic device 101 may include at least one capacitor. The electronic device 101 may include the first APT capacitor 361 and the second APT capacitor 362 for providing the supply voltage in accordance with the APT. The electronic device 101 may include decoupling capacitors for an RFFE module. For example, the electronic device 101 may include the first capacitor 351, the second capacitor 352, the third capacitor 353, a fourth capacitor 354, and a fifth capacitor 355. The first capacitor 351 may be connected to a path (e.g., the second path 292) from the second power supply circuitry 252 to the first RFFE module 241 to remove noise with respect to a DC signal to be supplied from the second power supply circuitry 252 to the first PA 261. The first capacitor 351 may be referred to as a bypass capacitor or a decoupling capacitor. The second capacitor 352 may be connected to a path (e.g., the power path 299) from an output voltage port Vₒᵤₜ of the first RFFE module 241 to the second RFFE module 242 to remove noise with respect to a DC signal to be supplied to the second PA 262 of the second RFFE module 242. The second capacitor 352 may be referred to as a bypass capacitor or a decoupling capacitor. The third capacitor 353 may be connected to a path to the third RFFE module 243 to remove noise with respect to a DC signal to be supplied to the third PA 263 of the third RFFE module 243. The third capacitor 353 may be referred to as a bypass capacitor or a decoupling capacitor. The fourth capacitor 354 may be connected to a path (e.g., the first path 291) to the first RFFE module 241 to remove noise with respect to a DC signal to be supplied to the first PA 261 of the first RFFE module 241 from the first power supply circuitry 251. The fourth capacitor 354 may be referred to as a bypass capacitor or a decoupling capacitor. The fifth capacitor 355 may be connected to a path to the fourth RFFE module 244 to remove noise with respect to a DC signal to be supplied to the fourth PA 264 of the fourth RFFE module 244. The fifth capacitor 355 may be referred to as a bypass capacitor or a decoupling capacitor.

According to embodiments of the present disclosure, the electronic device 101 may control the switching circuit 289 so that multiple capacitors are disposed in parallel on a path from the second power supply circuitry 252 to the third RFFE module 243 when transmitting a signal of a designated frequency band (e.g., the GSM frequency band, the frequency band for satellite communication, the frequency band of power class (PC) 1.5 among LTE frequency bands or NR frequency bands, the frequency band of PC 2 among LTE frequency bands or NR frequency bands, and the like) through the third RFFE module 243. In order to provide the supply voltage in accordance with the APT, a capacitor for stably maintaining the supply voltage may be required. Since higher-power signals consume more current, a larger capacitance may be required. In the present disclosure, the above-described requirements may be satisfied through a synthetic capacitance of capacitors disposed in parallel. In a case of transmitting a signal of the designated frequency band through the third RFFE module 243, the electronic device 101 may control the switching circuit 289 so that the power path 299 and the second path 292 are electrically connected. In the case of transmitting the signal of the designated frequency band through the third RFFE module 243, the electronic device 101 may disable all power amplifiers (e.g., the first PA 261 and the second PA 262) connected to the power path 299. As an example, the electronic device 101 may disable the first PA 261 and the second PA 262 through the first MIPI signal 231 of FIG. 2. As each power amplifier is disabled, it may be understood that a supply voltage is not applied to each power amplifier in the power path 299. Therefore, with respect to a path from the second power supply circuitry 252 to the third RFFE module 243, the first capacitor 351, the second capacitor 352, the third capacitor 353, and the second APT capacitor 362 may be electrically disposed in parallel.

The second supply voltage 254 based on APT from the second power supply circuitry 252 provided to the third RFFE module 243 may be affected by a synthetic capacitance of the first capacitor 351, the second capacitor 352, the third capacitor 353, and the second APT capacitor 362. As an example, if it is assumed that only the second APT capacitor 362 is connected to a path to the third RFFE module 243 when the supply voltage in accordance with the APT is provided for the third PA 263 of the third RFFE module 243, the second APT capacitor 362 may be required to have a capacity (e.g., approximately 4.7uF) greater than or equal to a certain size. However, through a connection of the switching circuit 289 and disabling of power amplifiers, capacitors disposed for RFFE modules may be electrically connected in parallel. Accordingly, even if the second APT capacitor 362 has a capacity smaller than 4.7 uF, the second supply voltage 254 in accordance with the APT may be stably provided to the third RFFE module 243. The synthetic capacitance of the first capacitor 351, the second capacitor 352, the third capacitor 353, and the second APT capacitor 362 may have a capacity greater than or equal to a certain size for maintaining the second supply voltage 254 in accordance with the APT. The electronic device 101 according to embodiments of the present disclosure may control the switching circuit 289 so that the power path 299 and the second power supply circuitry 252 are electrically connected while signals of the designated frequency band are transmitted through the third RFFE module 243 and all power amplifiers connected to the power path 299 are disabled. As the power path 299 is connected to the second power supply circuitry 252, the synthetic capacitance may be provided on the path from the second power supply circuitry 252 to the third RFFE module 243.

The third RFFE module 243 may support multiple frequency bands. As current consumption in a frequency band (e.g., the GSM frequency band, the frequency band for satellite communication, the frequency band of power class (PC) 1.5 among LTE frequency bands or NR frequency bands, the frequency band of PC 2 among LTE frequency bands or NR frequency bands, and the like) requiring a high output among the multiple frequency bands, is high, a large capacitance may be required. According to an embodiment, another frequency band different from the frequency band requiring the high output, supported in the third RFFE module 243, may be used for dual connectivity. Since the third RFFE module 243 receives power from the second power supply circuitry 252 through a separate path other than the power path 299, a power amplifier of another RFFE module (e.g., the first RFFE module 241 or the second RFFE module 242) connected to the power path 299 may be enabled. The power amplifier (e.g., enabled one of the connected power amplifiers) of the other RFFE module connected to the power path 299 may receive a supply voltage through the first power supply circuitry 251. Therefore, a frequency band supported in the first RFFE module 241, a frequency band supported in the second RFFE module 242, or a frequency band supported in the fourth RFFE module 244 (e.g., in this case, the switching circuit 289 is in an isolation state), and the other frequency band supported in the third RFFE module 243 may be used for DC.

In FIG. 3, examples in which a capacitor is connected to a wiring to each RFFE module are described, but the circuitry structure illustrated in FIG. 3 is exemplary and is not interpreted as limiting embodiments of the present disclosure. For example, the first capacitor 351 for the first RFFE module 241 is illustrated as one capacitor, but in implementation, multiple capacitors are disposed and it may be understood as an equivalent circuitry with respect to the multiple capacitors. For example, the second capacitor 352 for the second RFFE module 242 is illustrated as one capacitor, but in reality, it may be understood that multiple capacitors are disposed and as an equivalent circuitry with respect to the multiple capacitors. For example, the third capacitor 353 for the third RFFE module 243 is illustrated as one capacitor, but in reality, it may be understood that multiple capacitors are disposed and as an equivalent circuitry with respect to the multiple capacitors.

In other words, the circuitry structure illustrated through FIG. 3 or the following drawings referring to FIG. 3 is merely an example to describe indicating that at least one capacitor connected to the power path 299 is electrically connected to a capacitor connected to the second path 292 or a node on the second path 292, and a path on the third RFFE module 243, through the second path 292 and the power path 299 connected through the switching circuit 289. Therefore, the number of capacitors or a position of a capacitor illustrated in each drawing is not interpreted as limiting embodiments of the present disclosure. Each capacitor may be divided into multiple capacitors, or at least some of the illustrated capacitors may be implemented as one capacitor.

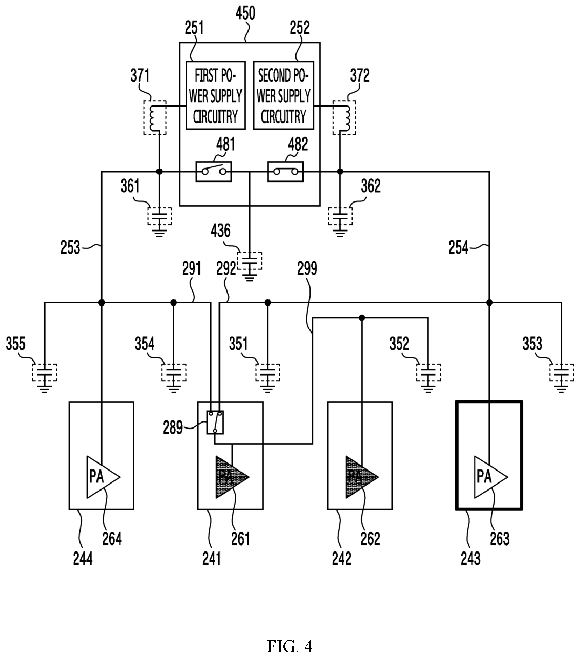

FIG. 4 indicates an example of an operation of a switching circuit in a power supply module for signal transmission in a designated frequency band. In FIG. 4, a circuitry structure in which power supply circuitry (e.g., a first power supply circuitry 251 and a second power supply circuitry 252) are included in one power supply module is described. According to an operation of the power supply module, a first supply voltage 253 and/or a second supply voltage 254 may be provided to RFFE modules (e.g., a first RFFE module 241, a second RFFE module 242, a third RFFE module 243, and/or a fourth RFFE module 244). The same reference number may be used for the same description. The descriptions of FIG. 3 may be used for FIG. 4.

Referring to FIG. 4, an electronic device 101 may include a power supply module 450. The power supply module 450 may include the first power supply circuitry 251 and the second power supply circuitry 252. The electronic device 101 may include a first APT capacitor 361, a second APT capacitor 362, a third APT capacitor 436, a first inductor 371, and a second inductor 372. For example, the first power supply circuitry 251 may provide the first supply voltage 253 based on APT. Buck converter circuitry of the first power supply circuitry 251 may be configured to output the first supply voltage 253 through the first inductor 371. The first power supply circuitry 251 may include a first APT switching circuit 481. The first APT switching circuit 481 may operate in accordance with control (e.g., a MIPI signal) of a processor 210 and/or an RF transceiver 220 of the electronic device 101. In order to provide the first supply voltage 253 based on the APT, the first APT switching circuit 481 may be configured to connect the first APT capacitor 361 and the third APT capacitor 436. In order to stably provide the first supply voltage 253 in accordance with the APT, the first APT capacitor 361 and the third APT capacitor 436 may be used. For example, the second power supply circuitry 252 may provide the second supply voltage 254 based on APT. Buck converter circuitry of the second power supply circuitry 252 may be configured to output the second supply voltage 254 through the second inductor 372. The second power supply circuitry 252 may include a second APT switching circuit 482. The second APT switching circuit 482 may operate in accordance with control (e.g., the MIPI signal) of the processor 210 and/or the RF transceiver 220 of the electronic device 101. In order to provide the second supply voltage 254 based on the APT, the second APT switching circuit 482 may be configured to connect the second APT capacitor 362 and the third APT capacitor 436. In order to stably provide the second supply voltage 254 in accordance with the APT, the second APT capacitor 362 and the third APT capacitor 436 may be used.

The electronic device 101 may include RFFE modules. For example, the electronic device 101 may include the first RFFE module 241, the second RFFE module 242, the third RFFE module 243, and/or the fourth RFFE module 244. The first RFFE module 241 may include a first PA 261. The second RFFE module 242 may include a second PA 262. The third RFFE module 243 may include a third PA 263. The fourth RFFE module 244 may include a fourth PA 264. The descriptions of the first PA 261, the second PA 262, the third PA 263, and the fourth PA 264 of FIG. 3 may be referenced for each PA.

The electronic device 101 may include at least one capacitor. The electronic device 101 may include the first APT capacitor 361, the second APT capacitor 362, and the third APT capacitor 436 for providing a supply voltage in accordance with APT. The electronic device 101 may include decoupling capacitors for an RFFE module. For example, the electronic device 101 may include a first capacitor 351, a second capacitor 352, a third capacitor 353, a fourth capacitor 354, and a fifth capacitor 355. The descriptions of the capacitors of FIG. 3 may be referenced for each capacitor.

The electronic device 101 may use capacitors disposed in parallel to provide the supply voltage in accordance with the APT to a high-output power amplifier. This is because high-output signals consume more current, and thus a large capacitance may be required. The electronic device 101 may control a switching circuit 289 so that a power path 299 and the second power supply circuitry 252 are electrically connected while signals of a designated frequency band (e.g., a GSM band) are transmitted through the third RFFE module 243 and all power amplifiers connected to the power path 299 are disabled. The switching circuit 289 may operate in accordance with control (e.g., a first MIPI signal 231) of the processor 210 and/or the RF transceiver 220 of the electronic device 101. As the power path 299 is connected to the second power supply circuitry 252, the synthetic capacitance may be provided on a path from the second power supply circuitry 252 to the third RFFE module 243.

The electronic device 101 may control the power supply module 450 to generate a supply voltage (e.g., the second supply voltage 254) based on APT through the second power supply circuitry 252 as well as the switching circuit 289. For example, the electronic device 101 may control the first APT switching circuit 481 and the second APT switching circuit 482 in accordance with control (e.g., the MIPI signal) of the processor 210 and/or the RF transceiver 220. According to an embodiment, while a signal of a designated frequency band (e.g., a GSM frequency band, a frequency band for satellite communication, a frequency band of power class (PC) 1.5 among LTE frequency bands or NR frequency bands, or a frequency band of PC 2 among LTE frequency bands or NR frequency bands) is transmitted through the third RFFE module 243, the first APT switching circuit 481 may be open, and the second APT switching circuit 482 may connect the third APT capacitor 436 and an output path of the second power supply circuitry 252. According to an embodiment, while signals of the designated frequency band (e.g., the GSM band, the frequency band for satellite communication, the frequency band of power class (PC) 1.5 among LTE frequency bands or NR frequency bands, or the frequency band of PC 2 among LTE frequency bands or NR frequency bands) are transmitted through the third RFFE module 243 and all power amplifiers connected to the power path 299 are disabled, the first APT switching circuit 481 may be open, and the second APT switching circuit 482 may connect the third APT capacitor 436 to the output path of the second power supply circuitry 252. According to an embodiment, while the third PA 263 is enabled and all power amplifiers connected to the power path 299 are disabled, the switching circuit 289 may electrically connect the second path 292 to the power path 299, the first APT switching circuit 481 may be open, and the second APT switching circuit 482 may connect the third APT capacitor 436 to the output path of the second power supply circuitry 252.

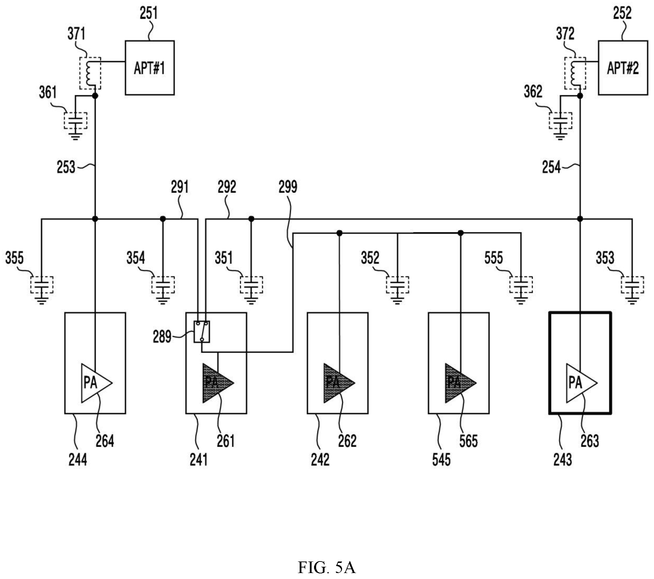

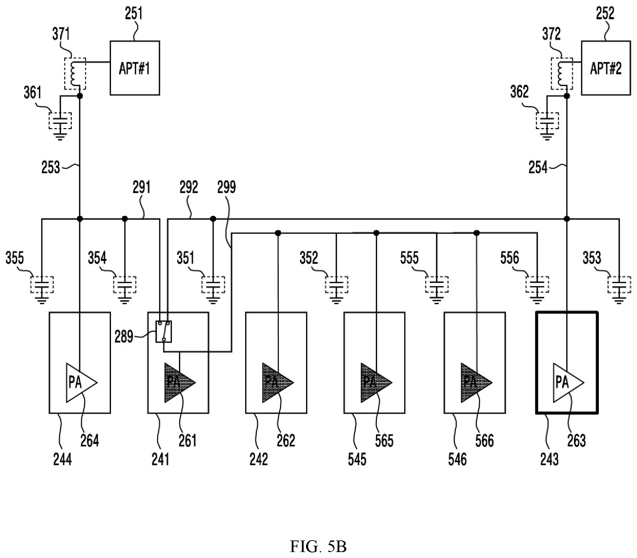

FIGS. 5A and 5B indicate an example of an operation of a switching circuit (e.g., a switching circuit 289) in an RFFE module for signal transmission in a designated frequency band. In FIGS. 5A and 5B, compared to FIG. 3, a circuitry structure in which additional RFFE modules are electrically connected to a power path (e.g., the power path 299) is described. For a supply voltage in accordance with APT, according to an operation of the switching circuit 289, a synthetic capacitance may be provided through capacitors for added RFFE modules. The same reference number may be used for the same description.

Referring to FIG. 5A, an electronic device 101 may include first power supply circuitry 251 and second power supply circuitry 252. For example, the first power supply circuitry 251 may provide a first supply voltage 253 based on APT. The second power supply circuitry 252 may provide a second supply voltage 254 based on APT. For APT capacitors (e.g., a first APT capacitor 361 and a second APT capacitor 362), inductors (e.g., a first inductor 371 and a second inductor 372), and power supply circuitry (e.g., the first power supply circuitry 251 and the second power supply circuitry 252), the descriptions of FIG. 3 may be referenced.

The electronic device 101 may include RFFE modules. For example, the electronic device 101 may include a first RFFE module 241, a second RFFE module 242, a third RFFE module 243, a fourth RFFE module 244, and a fifth RFFE module 545. The first RFFE module 241 may include a first PA 261. The second RFFE module 242 may include a second PA 262. The third RFFE module 243 may include a third PA 263. The fourth RFFE module 244 may include a fourth PA 264. The descriptions of the first PA 261, the second PA 262, the third PA 263, and the fourth PA 264 of FIG. 3 may be referenced for each PA. The fifth RFFE module 545 may include a fifth PA 565. The electronic device 101 may supply the first supply voltage 253 or the second supply voltage 254 to the fifth PA 565 of the fifth RFFE module 545 to drive the fifth PA 565. The electronic device 101 may provide the first supply voltage 253 or the second supply voltage 254 to the fifth PA 565 through the switching circuit 289 and the power path 299. As a non-limiting example, the fifth RFFE module 545 may be configured to perform processing of signals of a frequency band for EUTRA-NR (EN)-dual connectivity (DC).

As described above, the electronic device 101 according to embodiments of the present disclosure may control the switching circuit 289 to selectively connect a first path 291 or a second path 292 to the power path 299. For example, the switching circuit 289 may provide the first supply voltage 253 from the first power supply circuitry 251 to one of the power amplifiers (e.g., the first PA 261, the second PA 262, and the fifth PA 565) connected to the power path 299 in accordance with control of a processor 210 or an RF transceiver 220. For another example, the switching circuit 289 may provide the second supply voltage 254 from the second power supply circuitry 252 to one of the power amplifiers (e.g., the first PA 261, the second PA 262, and the fifth PA 565) connected to the power path 299 in accordance with control of the processor 210 or the RF transceiver 220. For another example, the switching circuit 289 may not electrically connect the power path 299 to both the first path 291 and the second path 292 in accordance with control of the processor 210 or the RF transceiver 220.

According to embodiments of the present disclosure, the switching circuit 289 may be configured to electrically connect the second path 292 and the power path 299 even if the second supply voltage 254 is not provided to any power amplifier of the power amplifiers (e.g., the first PA 261, the second PA 262, and the fifth PA 565) connected to the power path 299. The switching circuit 289 may be configured to electrically connect the second path 292 and the power path 299 while the power amplifiers (e.g., the first PA 261, the second PA 262, and the fifth PA 565) connected to the power path 299 are disabled and signals (e.g., a third transmission signal 233) are amplified through the third PA 263. The electronic device 101 may include at least one capacitor. The electronic device 101 may include decoupling capacitors for an RFFE module. For example, the electronic device 101 may include a first capacitor 351, a second capacitor 352, a third capacitor 353, a fourth capacitor 354, a fifth capacitor 355, and a sixth capacitor 555. The sixth capacitor 555 may be connected to a path (e.g., the power path 299) from an output voltage port Vₒᵤₜ of the first RFFE module 241 to the fifth RFFE module 545 to remove noise with respect to a DC signal to be supplied to the fifth PA 565 of the fifth RFFE module 545. The sixth capacitor 555 may be referred to as a bypass capacitor or a decoupling capacitor.

According to embodiments of the present disclosure, the electronic device 101 may control the switching circuit 289 so that multiple capacitors are disposed in parallel on a path from the second power supply circuitry 252 to the third RFFE module 243 when transmitting a signal of a designated frequency band (e.g., a GSM frequency band, a frequency band for satellite communication, a frequency band of power class (PC) 1.5 among LTE frequency bands or NR frequency bands, a frequency band of PC 2 among LTE frequency bands or NR frequency bands, and the like) through the third RFFE module 243. In a case of transmitting the signal of the designated frequency band through the third RFFE module 243, the electronic device 101 may disable all of the first PA 261, the second PA 262, and the fifth PA 565 connected to the power path 299. As an example, the electronic device 101 may control the first RFFE module 241, the second RFFE module 242, and the fifth RFFE module 545 through the same MIPI signal. Through the MIPI signal, a PA of each RFFE module may be disabled. Therefore, the first capacitor 351, the second capacitor 352, the third capacitor 353, and the sixth capacitor 555 may be electrically disposed in parallel with respect to the path from the second power supply circuitry 252 to the third RFFE module 243. By disposing not only three capacitors but also the sixth capacitor 555 for the fifth RFFE module 545 in parallel, a larger capacitance for APT may be secured.

Referring to FIG. 5B, the electronic device 101 may include the first power supply circuitry 251 and the second power supply circuitry 252. For example, the first power supply circuitry 251 may provide the first supply voltage 253 based on the APT. The second power supply circuitry 252 may provide the second supply voltage 254 based on the APT. For APT capacitors (e.g., the first APT capacitor 361 and the second APT capacitor 362), inductors (e.g., the first inductor 371 and the second inductor 372), and power supply circuitry (e.g., the first power supply circuitry 251 and the second power supply circuitry 252), the descriptions of FIG. 3 may be referenced.

The electronic device 101 may include RFFE modules. For example, the electronic device 101 may include the first RFFE module 241, the second RFFE module 242, the third RFFE module 243, the fourth RFFE module 244, the fifth RFFE module 545, and a sixth RFFE module 546. The first RFFE module 241 may include the first PA 261. The second RFFE module 242 may include the second PA 262. The third RFFE module 243 may include the third PA 263. The fourth RFFE module 244 may include the fourth PA 264. The fifth RFFE module 545 may include the fifth PA 565. The sixth RFFE module 546 may include the sixth PA 566. The descriptions of the first PA 261, the second PA 262, the third PA 263, and the fourth PA 264 of FIG. 3 and the descriptions of the fifth PA 565 of FIG. 5A may be referenced for each PA. The electronic device 101 may supply the first supply voltage 253 or the second supply voltage 254 to the sixth PA 566 of the sixth RFFE module 546 to drive the sixth PA 566. The electronic device 101 may provide the first supply voltage 253 or the second supply voltage 254 to the sixth PA 566 through the switching circuit 289 and the power path 299. As a non-limiting example, the sixth RFFE module 546 may be configured to process signals of a low frequency band (e.g., a frequency band less than approximately 1 GHz) among the frequency bands for EN-DC.

As described above, the electronic device 101 according to embodiments of the present disclosure may control the switching circuit 289 to selectively connect a first path 291 or a second path 292 to the power path 299. For example, the switching circuit 289 may provide the first supply voltage 253 from the first power supply circuitry 251 to one of power amplifiers (e.g., the first PA 261, the second PA 262, the fifth PA 565, and the sixth PA 566) connected to the power path 299 in accordance with control of the processor 210 or the RF transceiver 220. For another example, the switching circuit 289 may provide the second supply voltage 254 from the second power supply circuitry 252 to one of the power amplifiers (e.g., the first PA 261, the second PA 262, the fifth PA 565, and the sixth PA 566) connected to the power path 299 in accordance with control of the processor 210 or the RF transceiver 220. For another example, the switching circuit 289 may not electrically connect the power path 299 to both the first path 291 and the second path 292 in accordance with control of the processor 210 or the RF transceiver 220.

According to embodiments of the present disclosure, the switching circuit 289 may be configured to electrically connect the second path 292 and the power path 299 even if the second supply voltage 254 is not provided to any power amplifier of the power amplifiers (e.g., the first PA 261, the second PA 262, the fifth PA 565, and the sixth PA 566) connected to the power path 299. The switching circuit 289 may be configured to electrically connect the second path 292 and the power path 299 while the power amplifiers (e.g., the first PA 261, the second PA 262, the fifth PA 565, and the sixth PA 566) connected to the power path 299 are disabled and signals (e.g., the third transmission signal 233) are amplified through the third PA 263. The electronic device 101 may include at least one capacitor. The electronic device 101 may include decoupling capacitors for an RFFE module. For example, the electronic device 101 may include the first capacitor 351, the second capacitor 352, the third capacitor 353, the fourth capacitor 354, the fifth capacitor 355, the sixth capacitor 555, and a seventh capacitor 556. The seventh capacitor 557 may be connected to a path (e.g., the power path 299) from the output voltage port Vₒᵤₜ of the first RFFE module 241 to the sixth RFFE module 546 to remove noise with respect to a DC signal to be supplied to the sixth PA 566 of the sixth RFFE module 546. The seventh capacitor 556 may be referred to as a bypass capacitor or a decoupling capacitor.

According to embodiments of the present disclosure, the electronic device 101 may control the switching circuit 289 so that multiple capacitors are disposed in parallel on the path from the second power supply circuitry 252 to the third RFFE module 243 when transmitting the signal of the designated frequency band (e.g., the GSM frequency band, the frequency band for satellite communication, the frequency band of power class (PC) 1.5 among LTE frequency bands or NR frequency bands, the frequency band of PC 2 among LTE frequency bands or NR frequency bands, and the like) through the third RFFE module 243. In a case of transmitting the signal of the designated frequency band through the third RFFE module 243, the electronic device 101 may disable all of the first PA 261, the second PA 262, the fifth PA 565, and the sixth PA 566 connected to the power path 299. As an example, the electronic device 101 may control the first RFFE module 241, the second RFFE module 242, the fifth RFFE module 545, and the sixth RFFE module 546 through the same MIPI signal. Through the MIPI signal, a PA of each RFFE module may be disabled. Therefore, the first capacitor 351, the second capacitor 352, the third capacitor 353, the sixth capacitor 555 and the seventh capacitor 557 may be electrically disposed in parallel with respect to the path from the second power supply circuitry 252 to the third RFFE module 243. As all capacitors (e.g., the second capacitor 352, the sixth capacitor 555, and the seventh capacitor 557) connected to a power path are disposed in parallel, a capacitance of a larger capacity for the supply voltage in accordance with the APT may be secured.

Although individual power supply circuitry has been described in FIGS. 5A to 5B, embodiments of the present disclosure are not limited thereto. Instead of the first power supply circuitry 251 and the second power supply circuitry 252 individually disposed in FIGS. 5A or 5B, a power supply module 450 including the first power supply circuitry 251 and the second power supply circuitry 252 may be disposed. In this case, in the circuitry structure of FIGS. 5A and 5B, the operations of the electronic device 101 for controlling the power supply module 450 described in FIG. 4 may be additionally performed. For example, while the third PA 263 for the designated frequency band (e.g., the GSM band, the frequency band for satellite communication, the frequency band of power class (PC) 1.5 among LTE frequency bands or NR frequency bands, the frequency band of PC 2 among LTE frequency bands or NR frequency bands, and the like) is enabled and all power amplifiers connected to the power path 299 are disabled, the electronic device 101 may control the switching circuit 289 to electrically connect the second path 292 to the power path 299, may control a first APT switching circuit 481 to open the first APT switching circuit 481, and may control a second APT switching circuit 482 to connect a third APT capacitor 436 to an output path of the second power supply circuitry 252. For example, while signals of the designated frequency band (e.g., the GSM band, the frequency band for satellite communication, the frequency band of power class (PC) 1.5 among LTE frequency bands or NR frequency bands, the frequency band of PC 2 among LTE frequency bands or NR frequency bands, and the like) are transmitted through the third RFFE module 243 and all power amplifiers connected to the power path 299 are disabled, the electronic device 101 may control the switching circuit 289 to electrically connect the second path 292 to the power path 299, may control the first APT switching circuit 481 to open the first APT switching circuit 481, and may control the second APT switching circuit 482 to connect the third APT capacitor 436 to the output path of the second power supply circuitry 252.

In FIGS. 5A to 5B, the third RFFE module 243 may support multiple frequency bands. As current consumption in a frequency band (e.g., the GSM frequency band, the frequency band for satellite communication, the frequency band of power class (PC) 1.5 among LTE frequency bands or NR frequency bands, the frequency band of PC 2 among LTE frequency bands or NR frequency bands, and the like) requiring a high output among the multiple frequency bands is high, a large capacitance may be required. According to an embodiment, another frequency band different from the frequency band requiring the high output, supported in the third RFFE module 243, may be used for dual connectivity. Since the third RFFE module 243 receives power from the second power supply circuitry 252 through a separate path other than the power path 299, a power amplifier of another RFFE module (e.g., the first RFFE module 241, the second RFFE module 242, the fifth RFFE module 545, and the sixth RFFE module 546) connected to the power path 299 may be enabled. The power amplifier (e.g., enabled one of the connected power amplifiers) of the other RFFE module connected to the power path 299 may receive a supply voltage through the first power supply circuitry 251. Therefore, a frequency band supported in the first RFFE module 241, a frequency band supported in the second RFFE module 242, a frequency band supported in the fifth RFFE module 545, a frequency band supported in the sixth RFFE module 546, or a frequency band supported in the fourth RFFE module 244 (e.g., in this case, the switching circuit 289 is in an isolation state), and the other frequency band supported in the third RFFE module 243 may be used for DC.

In FIGS. 5A to 5B, examples in which a capacitor is connected to a wiring to each RFFE module are described, but the illustrated circuitry structure is exemplary and is not interpreted as limiting embodiments of the present disclosure. As an example, the sixth capacitor 555 for mitigating a noise component being introduced into the fifth RFFE module 545 or the seventh capacitor 556 for mitigating a noise component being introduced into the sixth RFFE module 546 are illustrated to be connected to the power path 299. However, at least one of capacitors (e.g., the second capacitor 352, the sixth capacitor 555, and the seventh capacitor 556) connected to the power path 299 may be implemented as one capacitor, and the one capacitor may be disposed closer to the first RFFE module 241 than each of the second RFFE module 242, the fifth RFFE module 545, and the sixth RFFE module 546.

In other words, the circuit structure exemplified through FIGS. 3 to 5B is merely an example to describe indicating that at least one capacitor connected to the power path 299 is electrically synthesized with a capacitor connecting a path on the third RFFE module 243 to the second path 292 or a node on the second path 292, through the second path 292 and the power path 299 connected through the switching circuit 289, and the number of capacitors or a position of a capacitor is not interpreted as limiting embodiments of the present disclosure. Each capacitor may be divided into multiple capacitors, or at least some of the illustrated capacitors may be implemented as one capacitor.

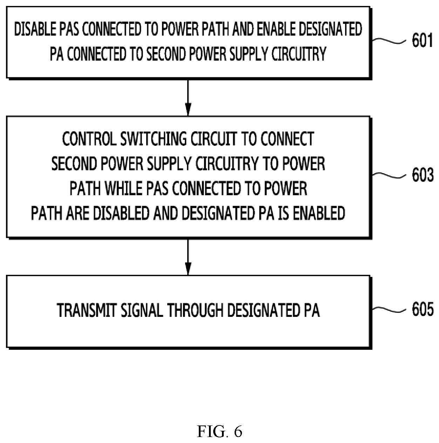

FIG. 6 indicates an operation flow of an electronic device (e.g., an electronic device 101) for transmitting a signal in a designated frequency band. The designated frequency band may be a frequency band that requires a relatively higher output (e.g., approximately 10 dB or more) than frequency bands in other RFFE modules. As an example, the designated frequency band may be a GSM frequency band. In the structure illustrated in FIGS. 3 to 5B, it is assumed that a third RFFE module 243 is configured to process signals of the designated frequency band.

Referring to FIG. 6, in an operation 601, the electronic device 101 may disable PAs (e.g., the first PA 261 and the second PA 262 of FIG. 3) connected to a power path (e.g., a power path 299), and may enable a designated PA (e.g., a third PA 263) connected to second power supply circuitry (e.g., second power supply circuitry 252). The power path may be connected to a switching circuit (e.g., a switching circuit 289) of an RFFE module (e.g., a first RFFE module 241) of the electronic device 101. Branches of the power path may be used to transmit a supply voltage to PAs (e.g., the first PA 261 and the second PA 262 of FIG. 3). A supply voltage of first power supply circuitry (e.g., first power supply circuitry 251) or the second power supply circuitry (e.g., the second power supply circuitry 252) may be provided to one of the PAs. If one of the PAs is enabled, remaining PA(s) may be disabled. In a case that a signal is to be transmitted through the designated PA, the electronic device 101 may disable all PAs connected to the power path. The designated PA may be configured to amplify the signals of the designated frequency band (e.g., a GSM band, a frequency band for satellite communication, a frequency band of power class (PC) 1.5 among LTE frequency bands or NR frequency bands, a frequency band of PC 2 among LTE frequency bands or NR frequency bands, and the like). The designated PA may be a PA connected to the second power supply circuitry and not connected to the power path. The second power supply circuitry may be configured to provide a supply voltage in accordance with APT. Even if the power path is electrically connected to the second power supply circuitry for a parallel disposition of capacitors to be described later, this is to prevent a supply voltage (e.g., a second supply voltage 254) by the second power supply circuitry from being provided to any PA among the PAs connected to the power path.

In an operation 603, the electronic device 101 may control the switching circuit (e.g., the switching circuit 289) to connect the second power supply circuitry (e.g., the second power supply circuitry 252) to the power path while the PAs (e.g., the first PA 261 and the second PA 262 of FIG. 3) connected to the power path (e.g., the power path 299) are disabled and the designated PA (e.g., the third PA 263) is enabled. The switching circuit may be configured to electrically connect the first power supply circuitry and the second power supply circuitry to one of the multiple PAs connected to the power path. For example, the electronic device 101 may provide one of the multiple PAs with a first supply voltage 253 from the first power supply circuitry 251 and the second supply voltage 254 from the second power supply circuitry 252 through the power path 299. If one of the PAs is enabled, the first supply voltage 253 or the second supply voltage 254 may be provided to the enabled PA. According to an embodiment, even if the multiple PAs connected to the power path 299 are disabled, the electronic device 101 may connect the power path 299 to a second path 292 through the switching circuit 289. The electronic device 101 may include decoupling capacitors for RFFE modules connected to the power path. The electronic device 101 may use a decoupling capacitor for an RFFE module of a non-enabled PA as a portion of an APT capacitor. The power path may be electrically connected to the second power supply circuitry through the switching circuit 289. At this time, as PAs of the RFFE modules connected to the power path are disabled, capacitors disposed for the RFFE modules may be electrically disposed in parallel.

In an operation 605, the electronic device 101 may transmit a signal through the designated PA (e.g., the third PA 263). The electronic device 101 may provide the supply voltage (e.g., the second supply voltage 254) in accordance with the APT to the designated PA. The supply voltage may be affected by a capacitance of capacitors connected on an electrical path from the second power supply circuitry to the designated PA. A high-output signal may require a high-capacity capacitance in order to stably maintain a voltage. As the PAs connected to the power path are disabled and the power path is electrically connected to the second power supply circuitry, the capacitors disposed in parallel may be electrically synthesized. As the capacitors are electrically synthesized, a high-capacity capacitance may be provided.

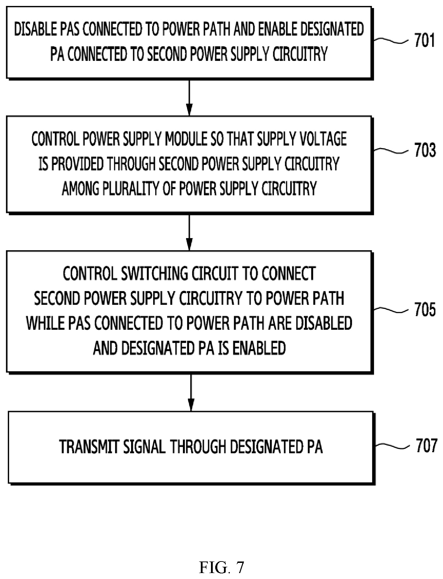

FIG. 7 indicates an operation flow of an electronic device (e.g., an electronic device 101) for transmitting a signal in a designated frequency band. The designated frequency band may be a frequency band that requires a relatively higher output (e.g., approximately 10 dB or more) than frequency bands in other RFFE modules. As an example, the designated frequency band may be a GSM frequency band. In the structure illustrated in FIG. 4, it is assumed that a third RFFE module 243 is configured to process signals of the designated frequency band.

Referring to FIG. 7, in an operation 701, the electronic device 101 may disable PAs (e.g., the first PA 261 and the second PA 262 of FIG. 3) connected to a power path (e.g., a power path 299), and may enable a designated PA connected to second power supply circuitry (e.g., second power supply circuitry 252). The electronic device 101 may include a power supply module (e.g., the power supply module 450 of FIG. 4). The power supply module 450 may include a plurality of power supply circuitry. A supply voltage from one of the plurality of power supply circuitry may be provided to one of the PAs. The designated PA may be connected to the second power supply circuitry among the plurality of power supply circuitry. In a case that a signal is to be transmitted through the designated PA, the electronic device 101 may disable all PAs connected to the power path. The designated PA may be configured to amplify the signals of the designated frequency band (e.g., a GSM band, a frequency band for satellite communication, a frequency band of power class (PC) 1.5 among LTE frequency bands or NR frequency bands, a frequency band of PC 2 among LTE frequency bands or NR frequency bands, and the like). The designated PA may be a PA connected to the second power supply circuitry and not connected to the power path. The second power supply circuitry may be configured to provide a supply voltage in accordance with APT. Even if the power path is electrically connected to the second power supply circuitry for a parallel disposition of capacitors to be described later, this is to prevent a supply voltage (e.g., a second supply voltage 254) by the second power supply circuitry from being provided to any PA among the PAs connected to the power path.

In an operation 703, the electronic device 101 may control the power supply module (e.g., the power supply module 450) so that the supply voltage (e.g., the second supply voltage 254) is provided through the second power supply circuitry (e.g., the second power supply circuitry 252) among the plurality of power supply circuitry. In a case of transmitting the signal through the designated PA, the electronic device 101 may control the power supply module to provide the supply voltage in accordance with the APT through the second power supply circuitry. The power supply module may include an APT switching circuit. The APT switching circuit may be configured to electrically connect an APT capacitor to an output path of buck converter circuitry in order to stably maintain the supply voltage in accordance with the APT when operating in an APT mode. According to an embodiment, the electronic device 101 may operate the APT switching circuit so that the supply voltage in accordance with the APT is provided through the second power supply circuitry. For example, the power supply module 450 may include a first APT switching circuit 481 for first power supply circuitry 251 and a second APT switching circuit 482 for the second power supply circuitry 252. The electronic device 101 may control the second APT switching circuit 482 to open the first APT switching circuit 481 and connect an APT capacitor (e.g., a third APT capacitor 436) to an output path of the second power supply circuitry 252.

In an operation 705, the electronic device 101 may control the switching circuit (e.g., the switching circuit 289) to connect the second power supply circuitry (e.g., the second power supply circuitry 252) to the power path while the PAs (e.g., the first PA 261, and the second PA 262 of FIG. 3) connected to the power path (e.g., the power path 299) are disabled and the designated PA is enabled. The descriptions of the operation 603 of FIG. 6 may be referenced for the operation 705.

In an operation 707, the electronic device 101 may transmit a signal through the designated PA. The electronic device 101 may provide the supply voltage (e.g., the second supply voltage 254) in accordance with the APT to the designated PA. The supply voltage may be affected by a capacitance of capacitors connected on an electrical path from the second power supply circuitry to the designated PA. The descriptions of the operation 605 of FIG. 6 may be referenced, for the operation 707.

In the present disclosure, an example in which the switching circuit 289 is illustrated in a first RFFE module 241 has been described, but embodiments of the present disclosure are not limited thereto. It may also be understood as an embodiment of the present disclosure that the switching circuit 289 is positioned outside the first RFFE module 241, and RFFE modules (e.g., the first RFFE module 241, a second RFFE module 242, a fifth RFFE module 545, and a sixth RFFE module 546) are connected to the power path 299 connected to an end of the switching circuit 289.

An electronic device (e.g., the electronic device 101) according to embodiments of the present disclosure may control a switching circuit (e.g., the switching circuit 289) so that capacitors of RFFE modules are disposed in parallel and may perform disabling of PAs connected to a power path (e.g., the power path 299) in providing a supply voltage in accordance with an APT mode for transmitting a high-output signal in a designated frequency band. Through this, capacitors may be utilized without mounting or disposing an additional capacitor. In addition, as a high-capacity capacitor (e.g., an MLCC capacitor) is not required to supply a voltage based on the APT, audible noise may be eliminated.

The effects that may be obtained from the present disclosure are not limited to those described above, and any other effects not mentioned herein will be clearly understood by those having ordinary knowledge in the art to which the present disclosure belongs, from the following description.

In embodiments, an electronic device 101 is provided. The electronic device 101 may comprise a processor 210 comprising one or more processing circuitry, a radio frequency (RF) transceiver 220, first power supply circuitry 251, second power supply circuitry 252 configured to provide a supply voltage based on average power tracking (APT), and a switching circuit 289 for selectively electrically connecting a power path 299 to one of the first power supply circuitry 251 and the second power supply circuitry 252, and may comprise a first radio frequency front end (RFFE) module including a first power amplifier 261 connected to the power path 299, a second RFFE module 242 including a second power amplifier 262 connected to the power path 299, a third RFFE module 243 including a third power amplifier 263 connected to the second power supply circuitry 252, at least one capacitor connected to the second power supply circuitry 252, and at least one capacitor connected to the power path 299. The switching circuit 289 may be configured to, in accordance with control of the processor 210 or the RF transceiver 220, connect the power path 299 and the second power supply circuitry 252 while power amplifiers connected to the power path 299, including the first power amplifier 261 and the second power amplifier 262, are disabled, and signals are transmitted through the third power amplifier 263 connected to the second power supply circuitry 252.

For example, the first power supply circuitry 251 and the second power supply circuitry 252 may be included in a power supply module 450. The power supply module 450 may be configured to, in accordance with control of the processor 210 or the RF transceiver 220, connect a capacitor for the APT to the second power supply circuitry 252, while the power amplifiers connected to the power path 299 are disabled and signals are transmitted through the third power amplifier 263 connected to the second power supply circuitry 252.

For example, the power supply module 450 may include a first APT switching circuit 481 for connecting first buck converter circuitry of the first power supply circuitry 251 and the capacitor, and a second APT switching circuit 482 for connecting second buck converter circuitry of the second power supply circuitry 252 and the capacitor. While the power amplifiers connected to the power path 299 are disabled and the signals are transmitted through the third power amplifier 263 connected to the second power supply circuitry 252, the first APT switching circuit 481 may be open and the second APT switching circuit 482 may be configured to connect the second buck converter circuitry of the second power supply circuitry and the capacitor.

For example, at least one capacitor connected to the second power supply circuitry 252 may include a first capacitor connected to a path between the second power supply circuitry 252 and the first RFFE module, and a third capacitor connected to a path between the second power supply circuitry 252 and the third RFFE module 243. At least one capacitor connected to the power path 299 may include a second capacitor. The first capacitor, the second capacitor, and the third capacitor may be used to provide the third RFFE module 243 with the supply voltage based on the APT from the second power supply circuitry 252.

For example, the first capacitor may be used for decoupling for the first RFFE module. The second capacitor may be used for decoupling for the second RFFE module 242. The third capacitor may be used for decoupling for the third RFFE module 243.

For example, the at least one capacitor connected to the second power supply circuitry 252 and the at least one capacitor connected to the power path 299 may be disposed in parallel with respect to an electrical path between the second power supply circuitry 252 and the third RFFE module 243, while the power amplifiers connected to the power path 299 are disabled and signals are transmitted through the third power amplifier 263 connected to the second power supply circuitry 252.

For example, the power path 299 may be configured to provide a supply voltage from the first power supply circuitry 251 and the second power supply circuitry 252 to one of the power amplifiers connected to the power path 299. A portion of the power path 299 may be disposed outside the first RFFE module and connected to the second RFFE module 242 through a voltage output port of the first RFFE module.

For example, the switching circuit 289 may configured to, in accordance with control of the processor 210 or the RF transceiver 220, connect the power path 299 and the second power supply circuitry 252, while signals are transmitted through one of the power amplifiers connected to the power path 299, and at least another of the power amplifiers and the third power amplifier 263 are disabled. While the power amplifiers connected to the power path 299 and the third power amplifier 263 are disabled, the switching circuit 289 may be configured to connect the power path 299 and the first power supply circuitry 251 or operate in an isolation state.

For example, a maximum power that may be outputted through the third power amplifier 263 may be higher than a maximum power that may be outputted through the first power amplifier 261 and may be higher than a maximum power that may be outputted through the second power amplifier 262.

For example, the third RFFE module 243 may be used to process the signals of a global system for mobile communications (GSM) band.

For example, the electronic device 101 may comprise a fourth RFFE module 244 including a fourth power amplifier connected to the first power supply circuitry 251. The switching circuit 289 may be configured to, in accordance with control of the processor 210 or the RF transceiver 220, connect the power path 299 and the first power supply circuitry 251, while the fourth power amplifier is disabled and the signals are transmitted through one of the power amplifiers connected to the power path 299.

For example, the electronic device 101 may comprise a fifth RFFE module including a fifth power amplifier connected to the power path 299, and a sixth RFFE module including a sixth power amplifier connected to the power path 299. While the signals are transmitted through the third power amplifiers 263, the disabled power amplifiers may include the first power amplifier 261, the second power amplifier 262, the fifth power amplifier, and the sixth power amplifier.

For example, the third RFFE module 243 may be configured to process signals of a frequency band in a first frequency range. Each of the first RFFE module and the second RFFE module 242 may be configured to process signals of a frequency band in a second frequency range higher than the first frequency range. The fourth RFFE module 244 may be configured to process signals of a frequency band between the first frequency range and the second frequency range. Each of the fifth RFFE module and the sixth RFFE module may be configured to process signals of a frequency band for EUTRA-NR (EN)- dual connectivity (DC).

For example, the at least one capacitor connected to the second power supply circuitry 252 may include a multilayer ceramic capacitor (MLCC).

In embodiments, an electronic device 101 is provided. The electronic device 101 may comprise a processor 210 comprising one or more processing circuitry, a radio frequency (RF) transceiver 220, a plurality of power supply circuitry including a power supply circuitry configured to provide a supply voltage based on average power tracking (APT), a first radio frequency front end (RFFE) module including a switching circuit 289 for selectively electrically connecting one of the plurality of power supply circuitry to a power path 299, at least one second RFFE module 242 connected to the power path 299, the third RFFE module 243 connected to a path from the power supply circuitry, at least one capacitor connected to the power supply circuitry, and at least one capacitor connected to the power path 299. The switching circuit 289 may be configured to, in accordance with control of the processor 210 or the RF transceiver 220, connect the power path 299 and the power supply circuitry while power amplifiers included in the first RFFE module and the at least one second RFFE module 242 are disabled and signals are transmitted through a power amplifier of the third RFFE module 243.

For example, the plurality of power supply circuitry may be included in a power supply module 450. The power supply module 450 may be configured to, in accordance with control of the processor 210 or the RF transceiver 220, connect a capacitor for the APT to the power supply circuitry, while the power amplifiers included in the first RFFE module and the at least one second RFFE module 242 are disabled and signals are transmitted through the power amplifier of the third RFFE module 243.

For example, at least one capacitor connected to the power supply circuitry may include a first capacitor connected to a path between the power supply circuitry and the first RFFE module, and a third capacitor connected to a path between the power supply circuitry and the third RFFE module 243. At least one capacitor connected to the power path 299 may include a second capacitor. The first capacitor, the second capacitor, and the third capacitor may be used to provide the third RFFE module 243 with the supply voltage based on the APT from the power supply circuitry.

For example, the at least one capacitor connected to the power supply circuitry and the at least one capacitor connected to the power path 299 may be disposed in parallel with respect to an electrical path between the power supply circuitry and the third RFFE module 243, while the power amplifiers connected to the power path 299 are disabled and signals are transmitted through a third power amplifier 263 connected to the power supply circuitry.

For example, a maximum power that may be outputted through the third power amplifier 263 may be higher than a maximum power that may be outputted through the first power amplifier 261 and may be higher than a maximum power that may be outputted through the second power amplifier 262.

For example, the third RFFE module 243 may be used to process the signals of a global system for mobile communications (GSM) band.

In embodiments, an electronic device 101 is provided. The electronic device 101 may comprise a processor 210 comprising processing circuitry, a radio frequency (RF) transceiver 220, first power supply circuitry 251 configured to provide a first supply voltage based on average power tracking (APT), second power supply circuitry 252 configured to provide a second supply voltage based on APT, a switching circuit 289 for selectively connecting a power path 299 to one of the first power supply circuitry 251 and the second power supply circuitry 252, a first radio frequency front end (RFFE) module 241 including a first power amplifier 261 connected to the power path 299, a second RFFE module 242 including a second power amplifier 262 connected to the power path 299, a third RFFE module 243 including a third power amplifier 263 connected to the second power supply circuitry 252, a first capacitor 351 connected to the first RFFE module 241, a second capacitor 352 connected to the second RFFE module 242, and a third capacitor 353 connected to the third RFFE module 243. The switching circuit 289 may be configured to, in accordance with control of the processor 210 or the RF transceiver 220, connect the power path 299 and the second power supply circuitry 252 while power amplifiers connected to the power path 299, including the first power amplifier 261 and the second power amplifier 262, are disabled, and the third power amplifier 263, connected to the second power supply circuitry 252, is enabled to transmit RF signals on a frequency band supported in the third RFFE module 243. The first capacitor 351, the second capacitor 352, and the third capacitor 353 may be used for the second supply voltage based on the APT while the power path and the second power supply circuitry 252 are connected. Transmit power for the frequency band supported in the third RFFE module 243 may be higher than transmit power for a frequency band supported in the first RFFE module 241 and may be higher than transmit power for a frequency band supported in the second RFFE module 242.

For example, the switching circuit 289 may be configured to, in accordance with control of the processor 210 or the RF transceiver 220, connect the power path and the second power supply circuitry 252 while one of the power amplifiers connected to the power path 299 is enabled and at least another amplifier of the power amplifiers and the third power amplifier 263 are disabled. The switching circuit 289 may be configured to operate in an isolation state or connect the power path 299 to the first power supply circuitry 251 while the power amplifiers connected to the power path 299 and the third power amplifier 263 are disabled.

For example, the second supply voltage based on the APT may be provided to the third power amplifier 263 through a path between the third RFFE module 243 and the second power supply circuitry 252. While the power path 299 and the second power supply circuitry 252 are connected, the first capacitor 351, the second capacitor 352, and the third capacitor 353 may be electrically connected to the path between the third RFFE module 243 and the second power supply circuitry 252, to maintain the second supply voltage based on the APT.

For example, the switching circuit 289 may be included in the first RFFE module 241.

For example, the first power supply circuitry 251 and the second power supply circuitry 252 may be included in a power supply module. The power supply module may be configured to, in accordance with control of the processor 210 or the RF transceiver 220, connect a fourth capacitor to the second power supply circuitry 252 while the power amplifiers connected to the power path 299 are disabled and the third power amplifier 263 is enabled.

For example, the power supply module may include a first APT switching circuit 289 for connecting first buck converter circuitry of the first power supply circuitry 251 and the capacitor, and a second APT switching circuit 289 for connecting second buck converter circuitry of the second power supply circuitry 252 and the capacitor. The power amplifiers connected to the power path 299 may be disabled. While the third power amplifier 263 connected to the second power supply circuitry 252 is enabled, the first APT switching circuit 289 may be opened. The second APT switching circuit 289 may be configured to connect the second buck converter circuitry of the second power supply circuitry 252 and the capacitor.

For example, through the power path 299 connected to the second power supply circuitry 252, the first capacitor 351, the second capacitor 352, and the third capacitor 353 may be coupled in parallel, in respect to an electric path between the second power supply circuitry 252 and the third RFFE module 243.

For example, the power path 299 may be configured to provide a supply voltage from the first power supply circuitry 251 and the second power supply circuitry 252 to one of the power amplifiers connected to the power path 299. A portion of the power path 299 may be disposed external to the first RFFE module 241 and connected to the second RFFE module 242 through a voltage output port of the first RFFE module 241.

For example, a maximum output power for the third power amplifier 263 may be higher than a maximum output power for the first power amplifier 261 and may be higher than a maximum output power for the second power amplifier 262.

For example, in a case that the third power amplifier 263 is enabled to transmit RF signals on the frequency band supported in the third RFFE module 243, the switching circuit 289 may be controlled to connect the power path 299 and the second power supply circuitry 252. In a case that the third power amplifier 263 is enabled to transmit RF signals on another frequency band supported in the third RFFE module 243, the switching circuit 289 may be controlled to connect the power path 299 and the first power supply circuitry 251 or operate in an isolation state.

For example, the frequency band supported in the third RFFE module 243 may comprise a global system for mobile communications (GSM) band. The another frequency band supported in the third RFFE module 243 may be usable for dual connectivity (DC) with a frequency band supported in the first RFFE module 241 or a frequency band supported in the second RFFE module 242.

For example, the electronic device 101 may comprise a fourth RFFE module 244 including a fourth power amplifier connected to the first power supply circuitry 251, a fifth RFFE module 545 including a fifth power amplifier connected to the power path 299, and a sixth RFFE module 546 including a sixth power amplifier connected to the power path 299. The disabled power amplifiers may include the fifth power amplifier and the sixth power amplifier. The third RFFE module 243 may be configured to process signals of a frequency band in a first frequency range. Each of the first RFFE module 241 and the second RFFE module 242 may be configured to process signals of a frequency band in a second frequency range higher than the first frequency range. The fourth RFFE module 244 may be configured to process signals of a frequency band between the first frequency range and the second frequency range. Each of the fifth RFFE module 545 and the sixth RFFE module 546 may be configured to process signals of a frequency band for EUTRA-NR (EN)-dual connectivity (DC).

For example, the first capacitor 351 may be connected to a first node connecting the first RFFE module 241 and the second power supply circuitry 252. The second capacitor 352 may be connected to a second node connecting the second RFFE module 242 and the switching circuit 289. The third capacitor 353 may be connected to a third node connecting the third RFFE module 243 and the second power supply circuitry 252.

For example, the electronic device 101 may comprise a multilayer ceramic capacitor (MLCC) connected to the second power supply circuitry 252.

In embodiments, an electronic device 101 is provided. The electronic device 101 may comprise a processor 210 comprising processing circuitry, a radio frequency (RF) transceiver 220, power supply circuitry configured to supply voltage based on average power tracking (APT), a switching circuit 289, a first radio frequency front end (RFFE) module 241 including a first power amplifier 261, a second RFFE module 242 including a second power amplifier 262, a third RFFE module 243 including a third power amplifier 263, a first path 292 provided between the power supply circuitry and the switching circuit 289, a second path 299 provided between the switching circuit 289 and each of power amplifiers including the first power amplifier 261 and the second power amplifier 262, a third path provided between a node on the first path 292 and the third power amplifier 263, a first capacitor 351 connected to the first path 292, a second capacitor 352 connected to the second path 299, and a third capacitor 353 connected to the third path. In a case that the first power amplifier 261 is enabled, the second power amplifier 262 is disabled, and the third power amplifier 263 is disabled, the switching circuit 289 may be controlled to connect the first power amplifier 261 to receive supply voltage from the power supply circuitry through the first path 292 and the second path 299 to amplify first RF signals from the RF transceiver 220 and transmit the amplified first RF signals on a first frequency band with first transmit power. In a case that the first power amplifier 261 is disabled, the second power amplifier 262 is enabled, and the third power amplifier 263 is disabled, the switching circuit 289 may be controlled to connect the second power amplifier 262 to receive supply voltage from the power supply circuitry through the first path 292 and the second path 299 to amplify second RF signals from the RF transceiver 220 and transmit the amplified second RF signals on a second frequency band with second transmit power. In a case that the first power amplifier 261 is disabled, the second power amplifier 262 is disabled, and the third power amplifier 263 is enabled, the switching circuit 289 may be controlled to connect the first path 292 and the second path 299 while the third power amplifier 263 is connected to receive supply voltage from the power supply circuitry through the third path to amplify third RF signals from the RF transceiver 220 and transmit the amplified third RF signals on a third frequency band with third transmit power. While the first path 292 and the second path 299 are connected, the first capacitor 351, the second capacitor 352, and the third capacitor 353 may be coupled in parallel. The third transmit power of the amplified third RF signals on the third frequency band may be higher than the first transmit power of the amplified first RF signals on the first frequency band and may be higher than the second transmit power of the amplified second RF signals on the second frequency band.

For example, in a case that the third power amplifier 263 is enabled to transmit the third RF signals on the third frequency band supported in the third RFFE module 243, the switching circuit 289 may be configured to connect the first path 292 and the second path 299, to use the first capacitor 351, the second capacitor 352, and the third capacitor 353 coupled in parallel, while providing the supply voltage based on the APT to the third power amplifier 263. In a case that the fourth power amplifier is enabled to transmit fourth RF signals on a fourth frequency band different from the third frequency band supported in the third RFFE module 243, the switching circuit 289 may be configured to operate in a state in which the first path 292 and the second path 299 are not connected, not to use the second capacitor 352 while providing the supply voltage based on the APT to the third power amplifier 263. While the switching circuit 289 is configured to operate in the state in which the first path 292 and the second path 299 are not connected, among the first capacitor 351, the second capacitor 352, and the third capacitor 353, the first capacitor 351 and the third capacitor 353 may be coupled in parallel.

For example, the third frequency band supported in the third RFFE module 243 may comprise a global system for mobile communications (GSM) band. The fourth frequency band supported in the third RFFE module 243 may be usable for dual connectivity (DC) with the first frequency band supported in the first RFFE module 241 or the second frequency band supported in the second RFFE module 242.

For example, the first capacitor 351 may be connected to a first node of the first path 292. The first node may connect the node connecting the power supply circuitry, the switching circuit 289, and the third RFFE module 243 and the first RFFE module 241. The second capacitor 352 may be connected to a second node of the second path 299. The second node may connect the switching circuit 289 to the second RFFE module 242. The third capacitor 353 may be connected to a third node of the third path. The third node may connect the node connecting the power supply circuitry, the switching circuit 289, and the third RFFE module 243 and the third RFFE module 243.

For example, the switching circuit 289 may be included in the first RFFE module 241.

For example, the electronic device 101 may include other power supply circuitry configured to supply a voltage based on APT or envelope tracking (ET), which is included in a power supply module. The power supply circuitry may be included in the power supply module. The power supply module may be configured to, in accordance with control of the processor 210 or the RF transceiver 220, connect a fourth capacitor to the first path 292, while the power amplifiers connected to the second path 299 are disabled and the third power amplifier 263 is enabled to transmit the third RF signals on the third frequency band supported in the third RFFE module 243.

In embodiments, an electronic device 101 is provided. The electronic device 101 may comprise a processor comprising processing circuitry, a radio frequency (RF) transceiver, power supply circuitry 252 configured to supply voltage based on average power tracking (APT), a switching circuit 289, a first radio frequency front end (RFFE) module 241 including a first power amplifier 261, a second RFFE module 242 including a second power amplifier 262, a third RFFE module 243 including a third power amplifier 263, a first path 292 provided between the power supply circuitry and the switching circuit 289, a second path 299 provided between the switching circuit 289 and each of power amplifiers including the first power amplifier 261 and the second power amplifier 262, a third path provided between a node on the first path 292 and the third power amplifier 263, a first capacitor 351 connected to the first path 292, a second capacitor 352 connected to the second path 299, and a third capacitor 353 connected to the third path. In a case that the first power amplifier 261 is disabled, the second power amplifier 262 is disabled, and the third power amplifier 263 is enabled to amplify first RF signals from the RF transceiver to be transmitted on a first frequency band supported in the third RFFE module 243 through an antenna, the switching circuit 289 may be configured to operate in a state in which the first path 292 and the second path 299 are not connected. In a case that the first power amplifier 261 is disabled, the second power amplifier 262 is disabled, and the third power amplifier 263 is enabled to amplify second RF signals from the RF transceiver to be transmitted on a second frequency band supported in the third RFFE module 243 through an antenna, the switching circuit 289 may be configured to connect the first path 292 and the second path 299 to use the first capacitor 351, the second capacitor 352, and the third capacitor 353 while the supply voltage based on the APT is provided to the third power amplifier 263.

The electronic device according to various embodiments may be one of various types of electronic devices. The electronic devices may include, for example, a portable communication device (e.g., a smartphone), a computer device, a portable multimedia device, a portable medical device, a camera, an electronic device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a processor comprising processing circuitry;
a radio frequency (RF) transceiver;
a first power supply circuitry configured to provide a first supply voltage based on average power tracking (APT);
a second power supply circuitry configured to provide a second supply voltage based on APT;
a switching circuit for selectively connecting a power path to one of the first power supply circuitry and the second power supply circuitry;
a first radio frequency front end (RFFE) module including a first power amplifier connected to the power path;
a second RFFE module including a second power amplifier connected to the power path;
a third RFFE module including a third power amplifier connected to the second power supply circuitry;
a first capacitor connected to the first RFFE module;
a second capacitor connected to the second RFFE module; and
a third capacitor connected to the third RFFE module,
wherein the switching circuit is configured to, in accordance with control of the processor or the RF transceiver:
connect the power path and the second power supply circuitry while power amplifiers connected to the power path, including the first power amplifier and the second power amplifier, are disabled and the third power amplifier, connected to the second power supply circuitry, is enabled to transmit RF signals on a frequency band supported in the third RFFE module,
wherein the first capacitor, the second capacitor, and the third capacitor are used for the second supply voltage based on the APT while the power path and the second power supply circuitry are connected, and
wherein transmit power for the frequency band supported in the third RFFE module is higher than transmit power for a frequency band supported in the first RFFE module and is higher than transmit power for a frequency band supported in the second RFFE module.

2. The electronic device of claim 1,
wherein the switching circuit is configured to, in accordance with control of the processor or the RF transceiver:
connect the power path and the second power supply circuitry while one of the power amplifiers connected to the power path is enabled and at least another amplifier of the power amplifiers and the third power amplifier are disabled, and
operate in an isolation state or connect the power path to the first power supply circuitry while the power amplifiers connected to the power path and the third power amplifier are disabled.

3. The electronic device of claim 1,
wherein the second supply voltage based on the APT is provided to the third power amplifier through a path between the third RFFE module and the second power supply circuitry, and
wherein, while the power path and the second power supply circuitry are connected, the first capacitor, the second capacitor, and the third capacitor are electrically connected to the path between the third RFFE module and the second power supply circuitry, to maintain the second supply voltage based on the APT.

4. The electronic device of claim 1, wherein the switching circuit is included in the first RFFE module.

5. The electronic device of claim 1,
wherein the first power supply circuitry and the second power supply circuitry are included in a power supply module,
wherein the power supply module is configured to, in accordance with control of the processor or the RF transceiver:
connect a fourth capacitor to the second power supply circuitry while the power amplifiers connected to the power path are disabled and the third power amplifier is enabled.

6. The electronic device of claim 5,
wherein the power supply module includes a first APT switching circuit for connecting a first buck converter circuitry of the first power supply circuitry and the capacitor, and a second APT switching circuit for connecting a second buck converter circuitry of the second power supply circuitry and the capacitor, and
wherein, while the power amplifiers connected to the power path are disabled and the third power amplifier connected to the second power supply circuitry is enabled, the first APT switching circuit is open and the second APT switching circuit is configured to connect the second buck converter circuitry of the second power supply circuitry and the capacitor.

7. The electronic device of claim 1,
wherein, through the power path connected to the second power supply circuitry, the first capacitor, the second capacitor, and the third capacitor are coupled in parallel, in respect to an electric path between the second power supply circuitry and the third RFFE module.

8. The electronic device of claim 1,
wherein the power path is configured to provide a supply voltage from the first power supply circuitry or the second power supply circuitry to one of the power amplifiers connected to the power path, and
wherein a portion of the power path is disposed external to the first RFFE module and connected to the second RFFE module through a voltage output port of the first RFFE module.

9. The electronic device of claim 1, wherein a maximum output power for the third power amplifier is higher than a maximum output power for the first power amplifier and is higher than a maximum output power for the second power amplifier.

10. The electronic device of claim 1,
wherein, in a case that the third power amplifier is enabled to transmit RF signals on the frequency band supported in the third RFFE module, the switching circuit is controlled to connect the power path and the second power supply circuitry, and
wherein, in a case that the third power amplifier is enabled to transmit RF signals on another frequency band supported in the third RFFE module, the switching circuit is controlled to connect the power path and the first power supply circuitry or operate in an isolation state.

11. The electronic device of claim 10,
wherein the frequency band supported in the third RFFE module comprises a global system for mobile communications (GSM) band, and
wherein the another frequency band supported in the third RFFE module is usable for dual connectivity (DC) with a frequency band supported in the first RFFE module or a frequency band supported in the second RFFE module.

12. The electronic device of claim 1, further comprising:
a fourth RFFE module including a fourth power amplifier connected to the first power supply circuitry;
a fifth RFFE module including a fifth power amplifier connected to the power path; and
a sixth RFFE module including a sixth power amplifier connected to the power path,
wherein the disabled power amplifiers include the fifth power amplifier and the sixth power amplifier,
wherein the third RFFE module is configured to process signals of a frequency band in a first frequency range,
wherein each of the first RFFE module and the second RFFE module is configured to process signals of a frequency band in a second frequency range higher than the first frequency range,
wherein the fourth RFFE module is configured to process signals of a frequency band between the first frequency range and the second frequency range, and
wherein each of the fifth RFFE module and the sixth RFFE module is configured to process signals of a frequency band for evolved universal mobile telecommunication system (UMTS) terrestrial radio access network (EUTRA) new radio (NR) dual connectivity (DC) (EN-DC).

13. The electronic device of claim 1,
wherein the first capacitor is connected to a first node connecting the first RFFE module and the second power supply circuitry,
wherein the second capacitor is connected to a second node connecting the second RFFE module and the switching circuit, and
wherein the third capacitor is connected to a third node connecting the third RFFE module and the second power supply circuitry.

14. The electronic device of claim 1, further comprising:
a multilayer ceramic capacitor (MLCC) connected to the second power supply circuitry.

15. An electronic device comprising:
a processor comprising processing circuitry;
a radio frequency (RF) transceiver;
a power supply circuitry configured to supply voltage based on average power tracking (APT);
a switching circuit;
a first radio frequency front end (RFFE) module including a first power amplifier;
a second RFFE module including a second power amplifier;
a third RFFE module including a third power amplifier;
a first path provided between the power supply circuitry and the switching circuit;
a second path provided between the switching circuit and each of power amplifiers including the first power amplifier and the second power amplifier;
a third path provided between a node on the first path and the third power amplifier,
a first capacitor connected to the first path;
a second capacitor connected to the second path; and
a third capacitor connected to the third path,
wherein, in a case that the first power amplifier is enabled, the second power amplifier is disabled, and the third power amplifier is disabled, the switching circuit is controlled to connect the first power amplifier to receive supply voltage from the power supply circuitry through the first path and the second path to amplify first RF signals from the RF transceiver and transmit the amplified first RF signals on a first frequency band with first transmit power,
wherein, in a case that the first power amplifier is disabled, the second power amplifier is enabled, and the third power amplifier is disabled, the switching circuit is controlled to connect the second power amplifier to receive supply voltage from the power supply circuitry through the first path and the second path to amplify second RF signals from the RF transceiver and transmit the amplified second RF signals on a second frequency band with second transmit power,
wherein, in a case that the first power amplifier is disabled, the second power amplifier is disabled, and the third power amplifier is enabled, the switching circuit is controlled to connect the first path and the second path while the third power amplifier is connected to receive supply voltage from the power supply circuitry through the third path to amplify third RF signals from the RF transceiver and transmit the amplified third RF signals on a third frequency band with third transmit power, and
wherein, while the first path and the second path are connected through the switching circuit, the first capacitor, the second capacitor, and the third capacitor are coupled in parallel, and
wherein the third transmit power of the amplified third RF signals on the third frequency band is higher than the first transmit power of the amplified first RF signals on the first frequency band and is higher than the second transmit power of the amplified second RF signals on the second frequency band.
